(19) **Europäisches Patentamt / European Patent Office / Office européen des brevets**

(11) **EP 4 742 239 A1**

(12) **EUROPEAN PATENT APPLICATION**
published in accordance with Art. 153(4) EPC

(43) Date of publication:
**13.05.2026 Bulletin 2026/20**

(21) Application number: **24835892.1**

(22) Date of filing: **18.06.2024**

(51) International Patent Classification (IPC):
*G10L 19/02* (2013.01)  *G10L 19/00* (2013.01)
*G10L 19/002* (2013.01)  *G10L 19/008* (2013.01)
*G10L 19/20* (2013.01)  *G10L 19/24* (2013.01)
*G10L 19/035* (2013.01)  *G10L 19/038* (2013.01)

(52) Cooperative Patent Classification (CPC):
**G10L 19/00; G10L 19/002; G10L 19/008;
G10L 19/02; G10L 19/035; G10L 19/038;
G10L 19/20; G10L 19/24**

(86) International application number:
**PCT/JP2024/021972**

(87) International publication number:
**WO 2025/009378 (09.01.2025 Gazette 2025/02)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **05.07.2023 JP 2023110467**

(71) Applicant: **Sony Group Corporation
Tokyo 108-0075 (JP)**

(72) Inventors:
• **TOGURI Yasuhiro
Tokyo 108-0075 (JP)**

• **HATTORI Takafumi
Tokyo 108-0075 (JP)**
• **SUZUKI Shiro
Tokyo 108-0075 (JP)**
• **KOTANI Rina
Tokyo 108-0075 (JP)**
• **MATSUMURA Yuuki
Tokyo 108-0075 (JP)**
• **KENMOCHI Chisato
Tokyo 108-0075 (JP)**

(74) Representative: **2SPL Patentanwälte PartG mbB
Landaubogen 3
81373 München (DE)**

(54) **DECODING DEVICE, DECODING METHOD, PROGRAM, AND ENCODING DEVICE**

(57) The present disclosure relates to a decoding device, a decoding method, a program, and an encoding device that can maintain good sound quality even at a low bit rate. A demultiplexing unit separates, from an encoded bitstream of a content signal, first encoded data obtained by encoding an envelope component of the content signal through frequency transform and second encoded data obtained by encoding a flattened waveform of the content signal with the number of bits different from the number of bits for the envelope component, for each band, a band decoding unit generates a band-divided signal by synthesizing the envelope component decoded from the first encoded data and the flattened waveform decoded from the second encoded data, and a band synthesis unit generates the content signal by synthesizing the band-divided signals of respective bands. The technology according to the present disclosure can be applied to, for example, an audio signal transmission system that transmits encoded bitstreams.

EP 4 742 239 A1

# Ｆ ｉ ｇ . 8

## Description

Technical Field

The present disclosure relates to a decoding device, a decoding method, a program, and an encoding device, and particularly relates to a decoding device, a decoding method, a program, and an encoding device that enable a good sound quality to be maintained even at a low bit rate.

Background Art

In recent years, the number of remote live events held has been increasing with the expansion of network transmission bandwidths. The term remote live refers to a real-time distribution of videos and audio recordings of a live performance by only performers or performers and spectators at a live event venue for an entertainment event such as music or a play to spectators (remote spectators) outside the live event venue.

In the distribution such as the remote live, high-quality audio signals need to be transmitted simultaneously to the terminals of a large number of remote spectators without losing the sense of presence at the live event venue. The existing waveform encoding scheme, however, has limitations in compression performance, and it is difficult to significantly lower the bit rate while maintaining the quality. On the other hand, according to parameter encoding in which the audio is modeled and synthesized as parameters, even though the bit rate can be lowered significantly, the target of the processing is limited to voice and the quality of general acoustic signals is degraded, making it difficult to perform transmission and reconstruction without losing the sense of presence at the live event venue.

In order to improve encoding efficiency, there is a method of extracting and encoding envelope components of the signal waveform or frequency spectrum. For example, PTL 1 discloses a technique of outputting an index by using a codebook of vector quantization for encoding envelope information.

Citation List

Patent Literature

PTL 1: Patent Application Laid-open No. 9-146593

Summary

Technical Problem

Meanwhile, it has been recently found that envelope components of audio signals significantly affect the auditory sense. However, in the existing encoding scheme, envelope components tend to be distorted at low bit rates, leading to problems in the auditory sense.

The present disclosure has been made in view of such circumstances, and is intended to bring a satisfactory sound quality even at low bit rates.

Solution to Problem

A decoding device according to a first aspect of the present disclosure is a decoding device including a demultiplexing unit configured to separate, from an encoded bitstream of a content signal, first encoded data obtained by encoding an envelope component of the content signal through frequency transform and second encoded data obtained by encoding a flattened waveform of the content signal with a number of bits different from the number of bits for the envelope component, for each band, a band decoding unit configured to generate a band-divided signal by synthesizing the envelope component decoded from the first encoded data and the flattened waveform decoded from the second encoded data, and a band synthesis unit configured to generate the content signal by synthesizing the band-divided signals of respective bands.

A decoding method according to the first aspect of the present disclosure is a decoding method including: by a decoding device, separating, from an encoded bitstream of a content signal, first encoded data obtained by encoding an envelope component of the content signal through frequency transform and second encoded data obtained by encoding a flattened waveform of the content signal with the number of bits different from the number of bits for the envelope component, for each band; by the decoding device, generating a band-divided signal by synthesizing the envelope component decoded from the first encoded data and the flattened waveform decoded from the second encoded data; and by the decoding device, generating the content signal by synthesizing the band-divided signals of respective bands.

A program according to the first aspect of the present disclosure is a program causing a computer to perform processing of separating, from an encoded bitstream of a content signal, first encoded data obtained by encoding an envelope component of the content signal through frequency transform and second encoded data obtained by encoding a flattened waveform of the content signal with the number of bits different from the number of bits for the envelope component, for each band, generating a band-divided signal by synthesizing the envelope component decoded from the first encoded data and the flattened waveform decoded from the second encoded data, and generating the content signal by synthesizing the band-divided signals of respective bands.

An encoding device according to a second aspect of the present disclosure is an encoding device including a band dividing unit configured to divide a content signal into band-divided signals of respective bands, a band encoding unit configured to separate the band-divided signal into an envelope component and a flattened waveform, encodes the envelope component through frequency transform, and encodes the flattened waveform with the number of bits different from the number of bits for the envelope component, and a multiplexing unit configured to generate an encoded bitstream by multiplexing first encoded data obtained by encoding the envelope component and second encoded data obtained by encoding the flattened waveform.

According to the first aspect of the present disclosure, first encoded data obtained by encoding an envelope component of the content signal through frequency transform and second encoded data obtained by encoding a flattened waveform of the content signal with the number of bits different from the number of bits for the envelope component are separated from an encoded bitstream of a content signal for each band, a band-divided signal is generated by synthesizing the envelope component decoded from the first encoded data and the flattened waveform decoded from the second encoded data, and the content signal is generated by synthesizing the band-divided signals of respective bands.

According to the second aspect of the present disclosure, a content signal is divided into band-divided signals of respective bands, the band-divided signal is separated into an envelope component and a flattened waveform, the envelope component is encoded through frequency transform, and the flattened waveform is encoded with the number of bits different from the number of bits for the envelope component, and an encoded bitstream is generated by multiplexing first encoded data obtained by encoding the envelope component and second encoded data obtained by encoding the flattened waveform.

Brief Description of Drawings

[Fig. 1] Fig. 1 is a diagram for describing a relationship between envelope components of an audio signal and timbre.
[Fig. 2] Fig. 2 is a diagram illustrating a configuration example of an audio signal transmission system according to an embodiment of the present disclosure.
[Fig. 3] Fig. 3 is a block diagram illustrating a functional configuration example of an encoding device.
[Fig. 4] Fig. 4 is a diagram for describing separation of an envelope component and a flattened waveform.
[Fig. 5] Fig. 5 is a diagram illustrating an example of parameters according to types of content.
[Fig. 6] Fig. 6 is a diagram illustrating an example of a transmission format of an encoded bitstream.
[Fig. 7] Fig. 7 is a flowchart for describing a flow of an encoding processing of an audio signal.
[Fig. 8] Fig. 8 is a block diagram illustrating a functional configuration example of a decoding device.
[Fig. 9] Fig. 9 is a block diagram illustrating a configuration example of a synthesis parameter determination unit.
[Fig. 10] Fig. 10 is a diagram illustrating an example of parameters according to types of content.
[Fig. 11] Fig. 11 is a block diagram illustrating a configuration example of an envelope weighting unit.
[Fig. 12] Fig. 12 is a diagram illustrating an example of weight information.
[Fig. 13] Fig. 13 is a block diagram illustrating another configuration example of the envelope weighting unit.
[Fig. 14] Fig. 14 is a diagram illustrating an example of training of parameters by a neural network.
[Fig. 15] Fig. 15 is a flowchart for describing a flow of a decoding processing of an audio signal.
[Fig. 16] Fig. 16 is a block diagram illustrating another functional configuration example of the decoding device.
[Fig. 17] Fig. 17 is a block diagram illustrating a configuration example of an envelope processing unit.
[Fig. 18] Fig. 18 is a block diagram illustrating another configuration example of the synthesis parameter determination unit.
[Fig. 19] Fig. 19 is a block diagram illustrating yet another configuration example of the synthesis parameter determination unit.
[Fig. 20] Fig. 20 is a block diagram illustrating yet another functional configuration example of the decoding device.
[Fig. 21] Fig. 21 is a block diagram illustrating another functional configuration example of the encoding device.
[Fig. 22] Fig. 22 is a diagram illustrating an example of an editing screen of a music production/editing tool.
[Fig. 23] Fig. 23 is a diagram illustrating an example of parameters corresponding to timbre.
[Fig. 24] Fig. 24 is a block diagram illustrating a configuration example of hardware of a computer.

Description of Embodiments

Hereinafter, modes for carrying out the present disclosure (hereinafter, referred to as embodiments) will be described. The descriptions will be given in the following order.

1. Related Art and Problems Thereof
2. Relationship between Envelope Components of Audio Signal and Timbre
3. Overview of Technology According to Present Disclosure and Audio Signal Transmission System
4. Configuration and Operation of Encoding Device
5. Configuration and Operation of Decoding Device
6. Variation of Decoding Device
7. Variation of Encoding Device and Music Production/Editing Tool
8. Summary
9. Configuration Example of Hardware of Computer

1. Related Art and Problems Thereof

Related Art

In recent years, the number of remote live events held has been increasing with the expansion of network transmission bandwidths. The term remote live refers to a real-time distribution of video and audio recordings of a live performance by only performers or performers and spectators at a live event venue for an entertainment event such as music or a play to spectators (remote spectators) outside the live event venue.

Among them, for example, a system is known in which, even when remote spectators join from outside the live event venue, videos reflecting the actions of other remote spectators are displayed to enhance the feeling of being part of the event or a sense of unity with the performer and other spectators during the live event. In addition, a system is operated in which remote spectators, selected in advance, record videos and audio using individual cameras and microphones, transmit the data in real time to the live event venue, and have videos of their facial expressions and motions displayed on the display of the live event venue with their sound output from the speaker, thereby enabling them to cheer from outside the live event venue.

In the distribution such as the remote live, high-quality audio signals need to be transmitted simultaneously to the terminals of a large number of remote spectators without losing the sense of presence of the live event venue. Furthermore, it is important for a large number of users to be able to transmit data simultaneously and bidirectionally with low delay in order to feed back responses, cheers, and the like from remote spectators to the live event venue. Recently, a huge amount of data has needed to be transmitted in order to transmit audio data together with high-quality video data, such as 4K videos. However, even though the bandwidths of network lines such as optical lines and 5G have been expanded, when several thousand to several tens of thousands of people join an event at the same time, the sense of presence of the content is greatly impaired due to network line congestion, an insufficient bandwidth causing connection difficulties, sound interruption, a long delay, and a very low sound quality.

In order to present such degradation in transmission quality, it is necessary to significantly reduce the information transmitted without losing the original sense of presence and quality of the content. Many sound encoding/compression techniques (codecs) have been studied for the purpose of reducing information transmitted. Examples of audio codecs in recent years include MPEG4 High-Efficiency Advanced Audio Coding (HE-AAC) (ISO/IEC 14496-3), 3rd Generation Partnership Project Enhanced Voice Services (3GPP (trade name) EVS), and the like.

Problem of Existing Encoding Scheme

The existing waveform encoding scheme, however, has limitations in compression performance, and it is difficult to significantly lower the bit rate while maintaining the quality. On the other hand, according to parameter encoding in which the audio is modeled and synthesized as parameters, even though the bit rate can be lowered significantly, the target of the processing is limited to voice and the quality of general acoustic signals is degraded, making it difficult to perform transmission and reconstruction without losing the sense of presence of the live event venue.

In addition, to improve encoding efficiency, there is a method of extracting and encoding envelope components of the signal waveform or frequency spectrum. For example, PTL 1 discloses a technique of outputting an index by using a codebook of vector quantization for encoding envelope information.

It has been recently found that envelope components of audio signals significantly affect the auditory sense. However, in the existing encoding scheme, since the quality of envelope components cannot be directly controlled, at low bit rates, the envelope components tend to be disturbed and problems in the auditory sense tend to occur.

Further, the existing encoding scheme is not intended to reproduce a subjective sense of presence or a way of feeling sound, which is greatly affected by envelope components, and a decoded audio signal cannot sufficiently reproduce a sense of presence that conveys the atmosphere of a live event venue or the like. Furthermore, in the related art, it is not easy for the distributor and the viewer to freely change the timbre conveying various atmospheres in accordance with the environment during distribution and reproduction.

2. Relationship between Envelope Components of Audio Signal and Timbre

There have been studies showing that an envelope component of a waveform is important in reproduction of an audio signal.

For example, Masayuki Takada "Calculation Methods of Sound Quality Metrics and Its Application", the Journal of the Acoustical Society of Japan, 2019, Vol. 75, No. 10, pp. 582 to 589, discloses a method of calculating a sound quality evaluation index such as "roughness" indicating the coarseness of a sound or "fluctuation strength" indicating the fluctuation of a sound, based on the fact that the intensity of an envelope component (amplitude modulation component) or the frequency (modulation frequency) thereof strongly affects the subjective perception of a sound such as the coarseness or the fluctuation of a sound. Further, it has been disclosed that the coarseness (roughness) of a sound occurs at a modulation frequency of 15 to 300 Hz, increases at 30 to 150 Hz, and particularly reaches the maximum level at around 70 Hz, and that the feeling of fluctuation (fluctuation strength) occurs at a modulation frequency of 20 Hz or lower, and particularly reaches the maximum level at 4 to 5 Hz.

"Modeling auditory processing of amplitude modulation. I. Detection and masking with narrow-band carriers" by Dau, T et al. in the Journal of the Acoustical Society of America vol. 102, 5 Pt 1 (1997): 2892-905, proposed a model for explaining the results of such psychophysical experiments. Here, it is assumed that the envelope component (amplitude modulation component) of the waveform after band-division by the "auditory filter bank" in the human auditory system is further analyzed by the "modulation filter bank".

Thus, the envelope components can be considered to play an important role in reproducing audio signals. Therefore, by extracting envelope components of audio signals and efficiently transmitting and reproducing the envelope components, the sense of presence may be efficiently reproduced with less transmission information. Furthermore, the encoding efficiency may be improved by encoding a component necessary for optimizing the subjective perception of a sound with high accuracy and coarsely quantizing or deleting an unimportant envelope component in accordance with the type of content or sound.

As described above, modulation frequency components (envelope components) play important roles in reproducing audio signals, and if unintended components are generated at a modulation frequency of around 30 to 150 Hz, which greatly affects the "roughness", for example, the coarseness of a harsh sound will be perceived.

Based on such knowledge, for example, S. van de Par, S. Disch, A. Niedermeier, and B. Edler "Informed postprocessing for auditory roughness removal for low-bitrate audio coders", AES Convention Paper 10534, (Oct. 2021) discloses a method of curbing modulation frequency components that are not present in the original sound and are generated during encoding by performing processing in the frequency spectrum domain (without extracting envelope components). As described above, in the related art, "unnecessary modulation frequency components" are only suppressed, and proactive change of the timbre by processing the modulation frequency components is not intended.

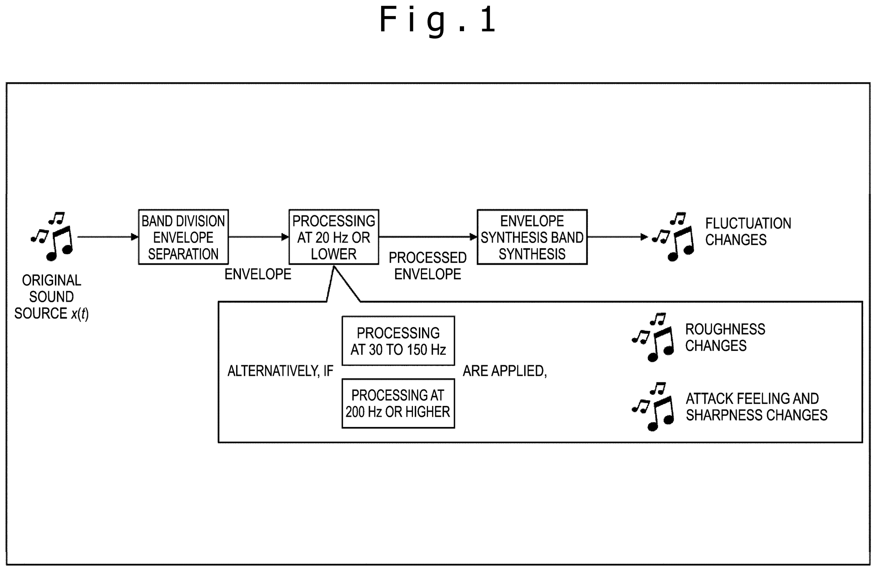

On the other hand, for example, as illustrated in Fig. 1, a signal x(t) of a sound source is band-divided and envelope-separated to extract envelope components, and some of the envelope components are processed to be envelope-synthesized and band-synthesized, thereby changing the signal to have appropriate timbre according to the preferences of the individual and the type of the sound source. For example, the feeling of fluctuation can be changed by processing envelope components below 20 Hz that affect "fluctuation strength". Alternatively, by reducing the envelope components at around 30 to 150 Hz, which affect "roughness", the roughness can be suppressed to change the sound into a calm sound easier to listen to, or by increasing the envelope components at 200 Hz or higher, an attack feeling, sharpness, and further a dry sensation can be emphasized.

In this manner, in addition to extracting and efficiently transmitting the envelope components of the audio signal, by processing some of the extracted envelope components according to the type of content or sound, it is easy to freely change the subjective perception of the sound during distribution or reproduction.

3. Overview of Technology According to Present Disclosure and Audio Signal Transmission System

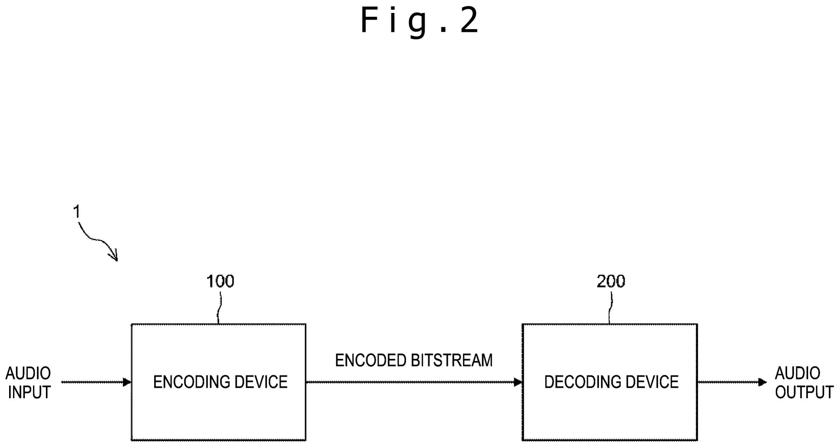

Fig. 2 is a diagram illustrating a configuration example of an audio signal transmission system according to an embodiment of the present disclosure.

The audio signal transmission system 1 illustrated in Fig. 2 is configured to include an encoding device 100 and a decoding device 200.

For example, the audio signal transmission system 1 may be configured as a system that realizes the remote live.

In this case, the encoding device 100 is configured as a server (distribution device) on the live event venue side, and the decoding device 200 is configured as a reproduction terminal on the remote spectator side.

In the audio signal transmission system 1, the encoding device 100 separates a band-divided signal obtained by dividing an input audio signal for each band into an envelope component and a flattened waveform other than the envelope component. In consideration of the fact that envelope components are highly important in the auditory sense, the encoding device 100 encodes and quantizes the envelope components by frequency transform, and encodes the flattened waveform with a smaller number of bits than that of the envelope components. In this manner, the encoded bitstream obtained by encoding the audio signal is transmitted to the decoding device 200.

The decoding device 200 decodes the encoded data of the envelope components and the encoded data of the flattened waveform for each band from the encoded bitstream transmitted from the encoding device 100. The decoding device 200 generates band-divided signals by synthesizing the decoded envelope components and the flattened waveform and outputs an audio signal by synthesizing the band-divided signals of the respective bands.

The encoding device 100 and the decoding device 200 will be described in detail below.

4. Configuration and Operation of Encoding Device Configuration of Encoding Device

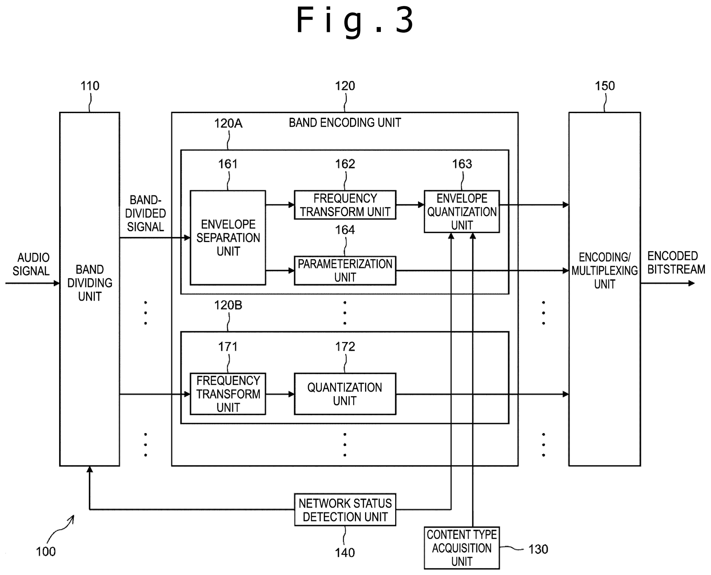

Fig. 3 is a block diagram illustrating a functional configuration example of the encoding device 100.

As illustrated in Fig. 3, the encoding device 100 includes a band dividing unit 110, a band encoding unit 120, a content type acquisition unit 130, a network status detection unit 140, and an encoding/multiplexing unit 150.

The band dividing unit 110 divides an audio signal input to the encoding device 100 into predetermined K bands (for example, K = 16) using a band-division filter. As the band-division filter, for example, a quadrature mirror filter (QMF), a polyphase quadrature filter (PQF), or the like is used. The band-divided signals divided for respective bands are supplied to the band encoding unit 120. Note that, although, basically, an audio signal is targeted for processing in the present embodiment while not limited thereto, a content signal including a video signal, a tactile signal, and other types of signals may be targeted for processing.

The band encoding unit 120 has a band encoding unit 120A and a band encoding unit 120B for encoding the band-divided signals of the respective bands. For example, the band encoding unit 120 is provided with the band encoding unit 120A corresponding to K' bands and the band encoding unit 120B corresponding to (K - K') bands among the K bands.

The band encoding unit 120A separates the envelope components and the flattened waveform from the band-divided signals, then encodes the envelope components through frequency transform, and encodes the flattened waveform with the number of bits different from that of the envelope components (to be more specific, the number of bits lower than that of the envelope components). On the other hand, the band encoding unit 120B encodes the band-divided signals through frequency transform without change (without separating the envelope components). Note that the flattened waveform may be encoded with a higher number of bits than the envelope components, rather than with a lower number of bits than the envelope components.

The band encoding unit 120A and the band encoding unit 120B need not be provided to correspond to continuous bands respectively. Each band is associated with either the band dividing unit 110 or the band encoding unit 120A, which only need be switched by the band encoding unit 120B.

That is, the band dividing unit 110 can determine, for each band, an encoding method of separating and encoding the envelope components and the flattened waveform from the band-divided signals or encoding the band-divided signals as they are.

In addition, the band to be associated with the band encoding unit 120A may be switched according to the transmission status of the network and the processing load of the reproduction terminals (decoding device 200), and for example, since the processing load of synthesizing the separated envelope components and flattened waveform is relatively large, in a case where the resource load of the reproduction terminal is large, the processing load of the reproduction terminals can be reduced by reducing the number of bands to be associated with the band encoding unit 120A.

In this case, the band dividing unit 110 can determine the band to be associated with the band encoding unit 120A based on the transmission status of the network detected by the network status detection unit 140 to be described below.

The band encoding unit 120A includes an envelope separation unit 161, a frequency transform unit 162, an envelope quantization unit 163, and a parameterization unit 164.

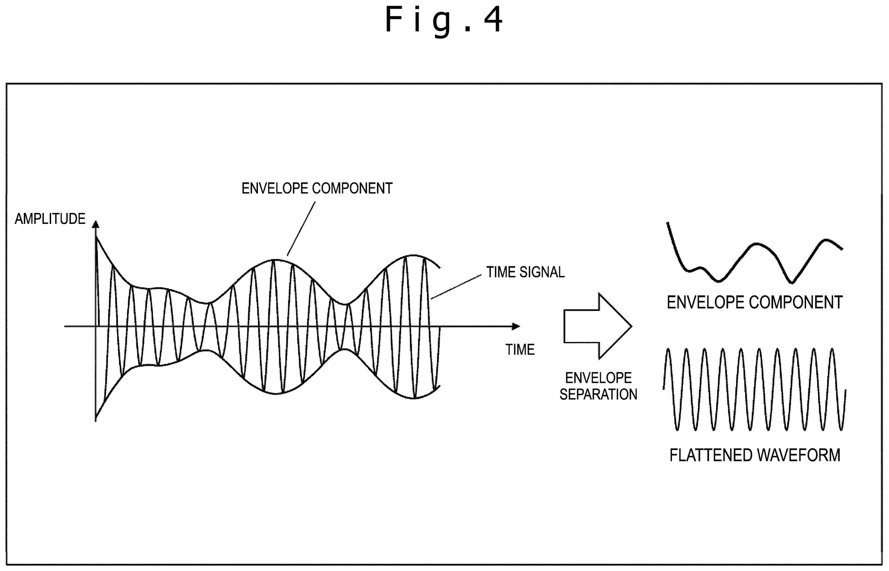

The envelope separation unit 161 separates a band-divided signal of each band into an envelope component and a component other than the envelope component. Specifically, the envelope separation unit 161 detects an envelope component of a time signal (band-divided signal) whose amplitude from the time axis varies, and separates the time signal into the envelope component and the component other than the envelope component (flattened waveform) as illustrated in Fig. 4. Although a method of separating the envelope component is not particularly limited, a method using Hilbert transform, a method of squaring a signal waveform and then passing the squared signal waveform through a low-pass filter, or the like is generally used. The separated envelope component is supplied to the frequency transform unit 162, and the flattened waveform is supplied to the parameterization unit 164.

The frequency transform unit 162 converts the envelope component from the envelope separation unit 161 into an envelope spectral coefficient by frequency transform, and supplies the envelope spectral coefficient to the envelope quantization unit 163. For the frequency transform, a modified discrete cosine transform (MDCT) is commonly used, but a discrete cosine transform (DCT), a discrete Fourier transform (DFT) filter bank, a cosine modulation filter bank, or the like may be used (transform encoding is equivalent to a filter bank).

Here, the content type acquisition unit 130 acquires the type of content or sound as the content type of the audio signal. The content type is acquired from metadata of the content or the like or automatically detected as information such as the program type or category information of a video content (music, news, movie, sports, or the like), the category (classic, pop, jazz, or the like) or musical instrument type of a music content, or the like. These content types may be selected by user input. In addition, when a content to be encoded is object data related to each sound source of audio, a musical instrument type or an object priority of the object only need be acquired as the content type.

In addition, the network status detection unit 140 acquires a transmission bit rate, an amount of latency, and the like from the system as transmission statuses of the network, and acquires a load processing state from the reproduction terminal (decoding device 200).

The envelope quantization unit 163 quantizes the envelope spectral coefficient from the frequency transform unit 162 with a predetermined number of bits based on the content type acquired by the content type acquisition unit 130 and the transmission status of the network detected by the network status detection unit 140, and outputs the obtained quantized spectrum to the encoding/multiplexing unit 150. The envelope spectral coefficient is normalized in units of predetermined quantization bands with a maximum value or the like in the quantization band, and is quantized with a predetermined number of bits.

At this time, bits are dynamically allocated so that the quantization accuracy of an important frequency band (hereinafter, also referred to as a "modulation frequency band") in the envelope component is high and the quantization accuracy of a modulation frequency band that is not so important is low, according to the type of content or sound obtained as the content type.

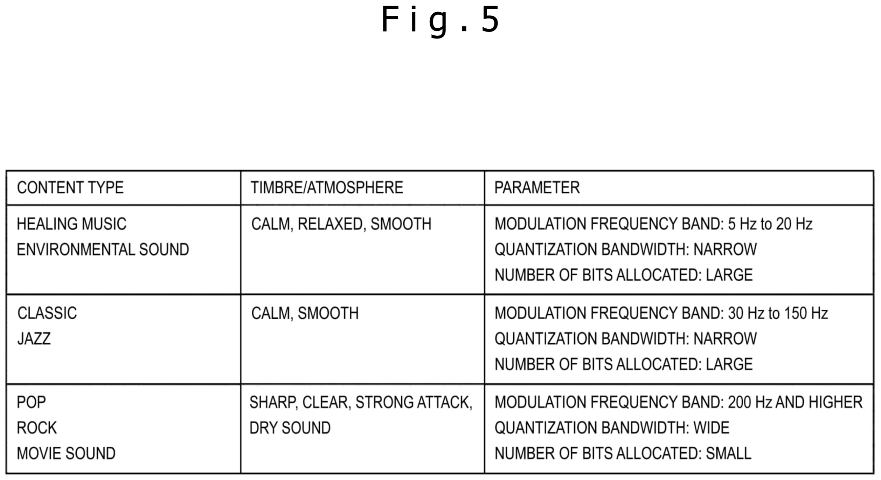

For example, when the content type is healing music, environmental sound, or the like, the type of sound (timbre and atmosphere) only need be calm, relaxed, or smooth as illustrated in Fig. 5. In this case, the modulation frequency band from 5 to 20 Hz is considered to be important, and the quantization bandwidth is narrowed and the number of bits to be allocated is increased for the band.

In addition, when the content type is classic, jazz, or the like, the type of sound (timbre and atmosphere) only need be calm and smooth. In this case, the modulation frequency band from 30 to 150 Hz is considered to be important, and the quantization bandwidth is narrowed and the number of bits to be allocated is increased for the band.

Further, when the content type is pop, rock, movie sound, or the like, the type of sound (timbre and atmosphere) only need be sharp, clear, a sound with a strong attack feeling, a dry sound, or the like. In this case, the modulation frequency band at 200 Hz or higher is considered to be less important, and the quantization bandwidth is increased and the number of bits allocated is reduced for the band.

In addition, bits may be dynamically allocated according to not only the type of content or sound but also the transmission status of the network or the object priority. For example, when the transmission status of the network is inadequate, the number of quantization bits of the modulation frequency band determined to not be particularly important for the content type is reduced, or the number of bits is not allocated so that the information on the band is not transmitted. Further, the processing load status of the reproduction terminal may be transmitted to the server (encoding device 100), and the band whose information is not transmitted may be determined according to the processing load status. Further, for an object with a low priority, the transmission band can be suppressed by reducing the number of bits allocated to the band and the modulation frequency band with low importance for the content, or by not allocating the number of bits so that the information is not transmitted.

The parameterization unit 164 performs parameter encoding for expressing the flattened waveform from the envelope separation unit 161 by a predetermined parameter. For example, in the parameter encoding, a plurality of signal waveform patterns are prepared in advance as a table, and the flattened waveform is replaced with the index number of the closest signal waveform pattern. In addition, when the flattened waveform is close to a sine wave or a multi-tone waveform, the flattened waveform may be transformed into sine wave parameters such as the frequency, gain, and phase of several sine waves. The flattening parameter obtained from the parameter encoding is output to the encoding/multiplexing unit 150.

On the other hand, the band encoding unit 120B is configured by a frequency transform unit 171 and a quantization unit 172.

The frequency transform unit 171 transforms the band-divided signal of each band into a frequency spectral coefficient by frequency transform, and supplies the frequency spectral coefficient to the quantization unit 172.

The quantization unit 172 quantizes the frequency spectral coefficient from the frequency transform unit 171 with a predetermined number of bits, and outputs the obtained quantized spectrum to the encoding/multiplexing unit 150.

Then, the encoding/multiplexing unit 150 transforms the quantized spectrum from the band encoding unit 120A (envelope quantization unit 163) of each band and the quantized spectrum from the band encoding unit 120B (quantization unit 172) of each band into an entropy code such as a Huffman code. Further, the encoding/multiplexing unit 150 multiplexes the converted entropy code in a predetermined format together with the flattening parameter from the band encoding unit 120A (parameterization unit 164) of each band, thereby generating an encoded bitstream.

Transmission Format of Encoded bitstream

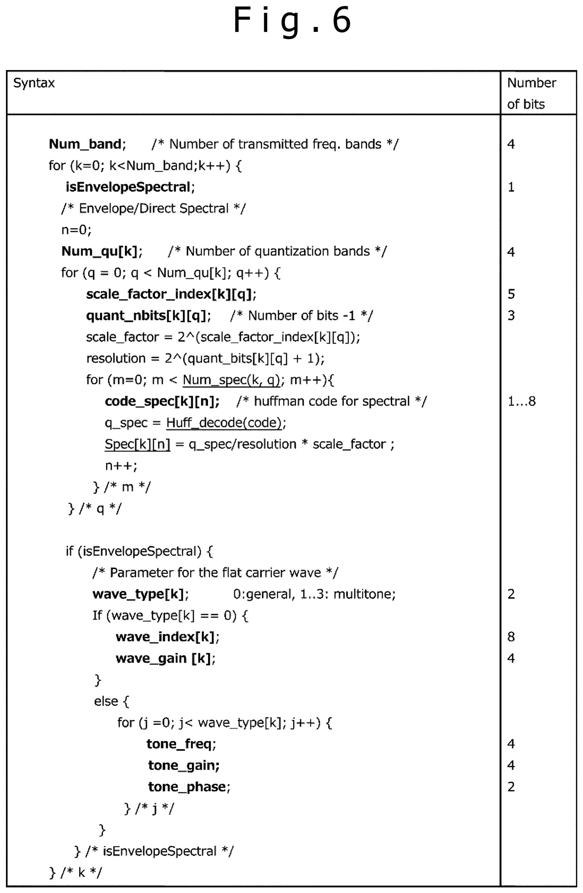

Fig. 6 is a diagram illustrating an example of a transmission format of an encoded bitstream.
In the example of Fig. 6, processing related to syntax of the transmission format is described. In Fig. 6, a description in bold represents syntax recorded in a bitstream, and the syntax is recorded with the number of bits described in the right column of the table. The description other than the bold description is an auxiliary description such as processing related to syntax or the number of loops.
Num_band is the number of transmitted bands, and is the number of band-divided signals that are encoded and transmitted to the decoding device 200, among the band-divided signals divided by the band dividing unit 110 in Fig. 3. For example, if the band-divided signal is divided into 16, Num_band is expressed in 4 bits. The number of transmitted bands is controlled according to the transmission status of the network detected by the network status detection unit 140, and when the transmission status is severe, the transmission band can be saved by reducing the number of transmitted bands.
isEnvelopeSpectral is a 1-bit flag, which indicates True if the spectral data of band k is the spectrum of the envelope components, and False if not. That is, isEnvelopeSpectral indicates whether the processing for band k includes processing of separating and synthesizing envelope components. When isEnvelopeSpectral is True, the subsequent spectrum represents an envelope spectrum, and when isEnvelopeSpectral is False, the subsequent spectrum represents a spectrum of the band-divided signal itself.
Num_qu[k] is the number of quantization bands transmitted in band k. The quantization band is a unit for quantizing a spectrum, and one quantization band includes several spectra. In the example of Fig. 6, Num_qu[k] is expressed in 4 bits. By changing the number of quantization bands according to the content type and the transmission status of the network, it is possible to reduce the information to be transmitted while maintaining the modulation frequency component that is subjectively important for the content. For example, based on the parameters of the important band for each content as illustrated in Fig. 5, the quantization band is determined so as to include the modulation frequency component important for the timbre and content according to the transmission status of the network.
Note that the algorithm for determining the quantization band based on the given Num_qu[k] is switched according to True/False of isEnvelopeSpectral. This is because a suitable quantization bandwidth is different between the spectrum of the envelope component and the spectrum of the band-divided signal itself.
scale_factor_index[k] [q] is an index of a scale factor in quantization band q of band k. The scale factor is a coefficient in normalizing a spectrum, and the index represents the exponent part of a power of 2. For example, if the number of bits is 5, normalization of $2^5 = 32$ levels can be expressed.
quant_nbits[k][q] represents a value {(the number of quantization bits) - 1} applied to band k and quantization band q (because 0 bits are not used). By changing the number of quantization bits of each spectrum according to the content type and the transmission status of the network, it is possible to efficiently reduce the information to be transmitted while maintaining the modulation frequency component that is subjectively important for the content. Similar to the number of quantization bands described above, a greater number of bits can be allocated to the frequency components important for the content and the modulation frequency components based on the parameters as illustrated in Fig. 5.
Num_spec(k, q) indicated with underscore is a function for acquiring a quantization bandwidth (the number of spectra included) in band k and quantization band q. The quantization bandwidth of each band is defined in advance.
code_spec[k] [q] is a code of a spectrum that is entropy-encoded by Huffman codes or the like. Since the code is a variable length code, the number of bits is variable. Huff_decode() indicated with underscore is a function for decoding a Huffman code using a specified table to obtain a quantized spectrum. Although an example of encoding spectral coefficients one by one is illustrated here for simplicity, the same applies to multidimensional Huffman codes in which a plurality of spectra are grouped.
The spectral coefficient Spec[k] [n] of band k, which is indicated with underscore, is obtained by dividing the decoded quantized spectrum by the quantization accuracy resolution to perform inverse quantization, and further multiplying the result by a scale factor to perform inverse normalization thereon. As described above, if isEnvelopeSpectral is True, the spectral coefficient to be obtained is the spectrum of the envelope components, and if isEnvelopeSpectral is False, the spectral coefficient to be obtained is the spectrum of the band-divided signal itself.
If isEnvelopeSpectral is True, information of the flattened waveform (carrier-wave signal) that has been further parameter-encoded is recorded. wave_type[k] represents the type of the flattened waveform of band k. Here, 0 represents a general waveform such as noise or a composite signal. The numbers 1 to 3 represent multi-tones consisting of the representing number of sine waves. When wave_type[k] represents a general waveform, wave_index[k] represents the index of a waveform pattern, and wave_gain[k] represents the gain index thereof. A flattened waveform is generated using a waveform pattern and a gain corresponding to the index. In addition, when wave_type[k] represents multi-tone, the frequency index tone_freq, the gain index tone_gain, and the phase index tone_phase of the tone are repeatedly recorded by the number of tones.

Based on the transmission format as described above, the encoded bitstream generated in the encoding device 100 is transmitted to the decoding device 200.

Operation of Encoding Device

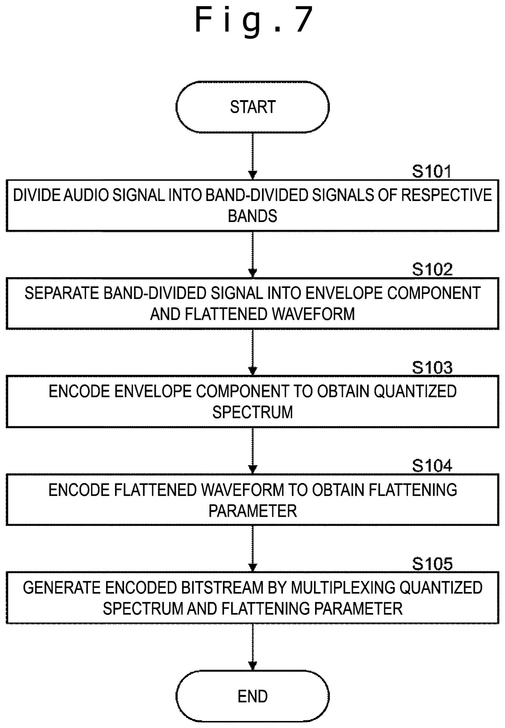

Next, the flow of an encoding processing of an audio signal by the encoding device 100 will be described with reference to the flowchart of Fig. 7. In Fig. 7, the flow of the encoding processing for the band of which isEnvelopeSpectral is True will be mainly described, but the encoding processing for the band of which isEnvelopeSpectral is False is also performed in parallel.

In step S101, the band dividing unit 110 divides the audio signal input to the encoding device 100 into band-divided signals of respective bands.

In step S102, the band encoding unit 120A (envelope separation unit 161) separates the band-divided signal of each band into an envelope component and a flattened waveform.

In step S103, the band encoding unit 120A (the frequency transform unit 162 and the envelope quantization unit 163) obtains a quantized spectrum by encoding the envelope component. Specifically, the frequency transform unit 162 transforms the envelope component into an envelope spectral coefficient by frequency transform, and the envelope quantization unit 163 quantizes the envelope spectral coefficient to acquire the quantized spectrum.

In step S104, the band encoding unit 120A (parameterization unit 164) encodes the flattened waveform through parameter encoding to acquire a flattening parameter.

In step S105, the encoding/multiplexing unit 150 generates an encoded bitstream by multiplexing the quantized spectra and the flattening parameters of the respective bands.

According to the above configuration and processing, the band-divided signal is separated into an envelope component and a component other than the envelope component, the envelope component important for the timbre and sound atmosphere is encoded through frequency transform with high accuracy, and the component other than the envelope component is encoded with a smaller number of bits, so the reconstruction can be performed without losing the original timbre and sound atmosphere, and further the sense of presence even if it is transmitted with a small amount of information. That is, it is possible to maintain good sound quality even at a low bit rate.

5. Configuration and Operation of Decoding Device Configuration of Decoding Device

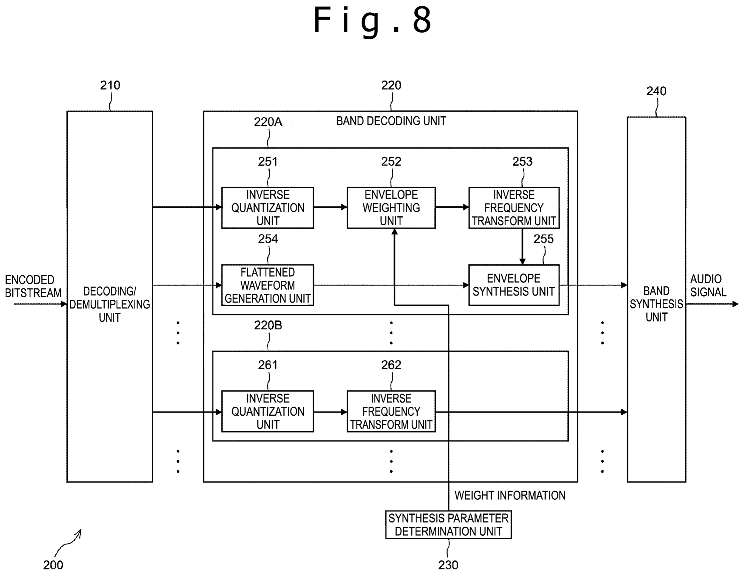

Fig. 8 is a block diagram illustrating a functional configuration example of the decoding device 200.

The decoding device 200 includes a decoding/demultiplexing unit 210, a band decoding unit 220, a synthesis parameter determination unit 230, and a band synthesis unit 240 as illustrated in Fig. 8.

The decoding/demultiplexing unit 210 performs a decoding processing on the encoded bitstream of the audio signal input to the decoding device 200.

Specifically, the decoding/demultiplexing unit 210 separates, from the encoded bitstream of the audio signal, a quantized spectrum (first encoded data) obtained by encoding the envelope component of the audio signal by frequency transform and a flattening parameter (second encoded data) obtained by encoding (parameter-encoding) the flattened waveform of the audio signal with a smaller number of bits than the envelope component, for each band. In addition, the decoding/demultiplexing unit 210 separates, from the encoded bitstream of the audio signal, the frequency spectrum (third encoded data) obtained by performing frequency transform on the band-divided signal itself for each band.

At this time, the decoding/demultiplexing unit 210 determines, for each band, whether to separate the quantized spectrum and the flattening parameter or to separate only the quantized spectrum according to a flag (isEnvelopeSpectral) included in the encoded bitstream. That is, if isEnvelopeSpectral is True, the quantized spectrum and the flattening parameter are separated from the encoded bitstream of the band, and if isEnvelopeSpectral is False, only the quantized spectrum (frequency spectrum obtained by performing frequency transform on the band-divided signal itself) is separated from the encoded bitstream of the band. The quantized spectrum (flattening parameter) separated for each band is supplied to the band decoding unit 220.

The band decoding unit 220 includes a band decoding unit 220A and a band decoding unit 220B for decoding the quantized spectrum (the flattening parameter) of each band. For example, the band decoding unit 220 is provided with the band decoding unit 220A corresponding to K' bands among the K bands and the band decoding unit 220B corresponding to (K - K') bands.

The band decoding unit 220A generates a band-divided signal by synthesizing envelope components decoded from the quantized spectrum and the flattened waveform decoded from the flattening parameter, for a band whose isEnvelopeSpectral is True. On the other hand, the band decoding unit 220B outputs a band-divided signal decoded from the quantized spectrum for a band whose isEnvelopeSpectral is False.

The band decoding unit 220A and the band decoding unit 220B need not be provided to correspond to continuous bands respectively. Note that which of the band decoding unit 220A and the band decoding unit 220B is to be associated with each band only need be switched depending on isEnvelopeSpectral included in the encoded bitstream.

The band decoding unit 220A includes an inverse quantization unit 251, an envelope weighting unit 252, an inverse frequency transform unit 253, a flattened waveform generation unit 254, and an envelope synthesis unit 255.

The inverse quantization unit 251 performs predetermined inverse quantization processing, such as restoring a quantization index to a spectrum or multiplying the quantization index by an inverse gain of normalization processing, on the quantized spectrum from the decoding/demultiplexing unit 210, thereby acquiring N envelope spectral coefficients. Here, N is the number of frequency bins when the envelope components are frequency-transformed. The envelope spectral coefficients are supplied to the envelope weighting unit 252.

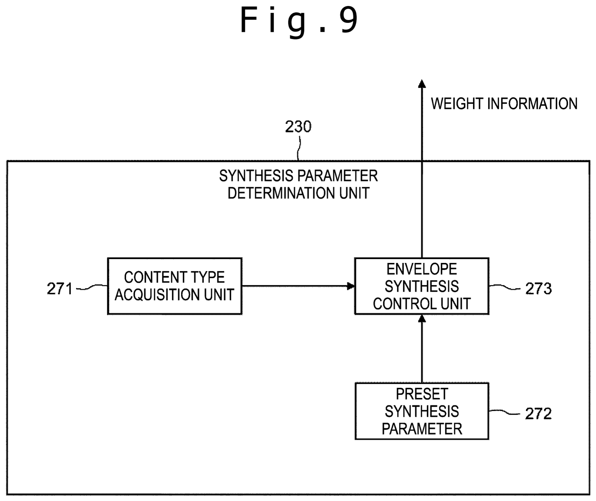

The envelope weighting unit 252 performs a weighting processing related to the envelope spectral coefficient of each band based on the weight information (synthesis parameter) supplied from the synthesis parameter determination unit 230. Specifically, the envelope weighting unit 252 multiplies the envelope spectral coefficient by a weighting coefficient that is different for each frequency bin based on the weight information from the synthesis parameter determination unit 230, thereby acquiring a weighted envelope spectral coefficient. The obtained weighted envelope spectral coefficient is supplied to the inverse frequency transform unit 253. The synthesis parameter determination unit 230 determines weight information for setting a weighting coefficient in the weighting processing by using any of parameters prepared in advance. Details of the synthesis parameter determination unit 230 and the weight information will be described below with reference to Fig. 9.

The inverse frequency transform unit 253 restores the weighted envelope spectral coefficient from the envelope weighting unit 252 to a time signal of the envelope component through an inverse frequency transform, and supplies the time signal to the envelope synthesis unit 255.

Then, the flattened waveform generation unit 254 generates a flattened waveform by generating a signal waveform of a pattern corresponding to a parameter index from the flattening parameter from the decoding/demultiplexing unit 210 and synthesizing a multi-tone from a sine wave parameter. The obtained flattened waveform is supplied to the envelope synthesis unit 255.

The envelope synthesis unit 255 generates a band-divided signal by synthesizing the envelope component from the inverse frequency transform unit 253 and the flattened waveform from the flattened waveform generation unit 254. The band-divided signal is generated by performing amplitude modulation with the envelope component on the flattened waveform as a carrier wave. The generated band-divided signal is output to the band synthesis unit 240.

On the other hand, the band decoding unit 220B includes an inverse quantization unit 261 and an inverse frequency transform unit 262.

The inverse quantization unit 261 performs predetermined inverse quantization processing on the quantized spectrum from the decoding/demultiplexing unit 210 to acquire a frequency spectral coefficient, and supplies the frequency spectral coefficient to the inverse frequency transform unit 262.

The inverse frequency transform unit 262 restores the frequency spectral coefficient from the inverse quantization unit 261 to a band-divided signal through an inverse frequency transform, and outputs the band-divided signal to the band synthesis unit 240.

Then, the band synthesis unit 240 synthesizes the band-divided signals of the respective bands from the band decoding unit 220 by using a synthesis filter bank, thereby generating an audio signal of a time waveform signal.

Configuration of Synthesis Parameter Determination Unit

Here, a configuration of the synthesis parameter determination unit 230 will be described with reference to Fig. 9.

As illustrated in Fig. 9, the synthesis parameter determination unit 230 includes a content type acquisition unit 271, a preset synthesis parameter 272, and an envelope synthesis control unit 273.

The content type acquisition unit 271 has the same function as the content type acquisition unit 130 in Fig. 7, and acquires the type of content or sound as the content type of the audio signal. The content type is acquired from metadata of the content or the like or automatically detected as information, for example, the program type of a video content (music, news, movie, sports, or the like) or category information, the category (classic, pop, jazz, or the like) or the musical instrument type of a music content, or the like. These content types may be selected by user input. In addition, when a content to be encoded is data of an audio object (audio object data), a musical instrument type or an object priority of the audio object, for example, only need be acquired as the content type.

The preset synthesis parameter 272 is a preset parameter (parameter set) for weighting the envelope component to have timbre and a sound atmosphere corresponding to the sound or the type of the content obtained as the content type.

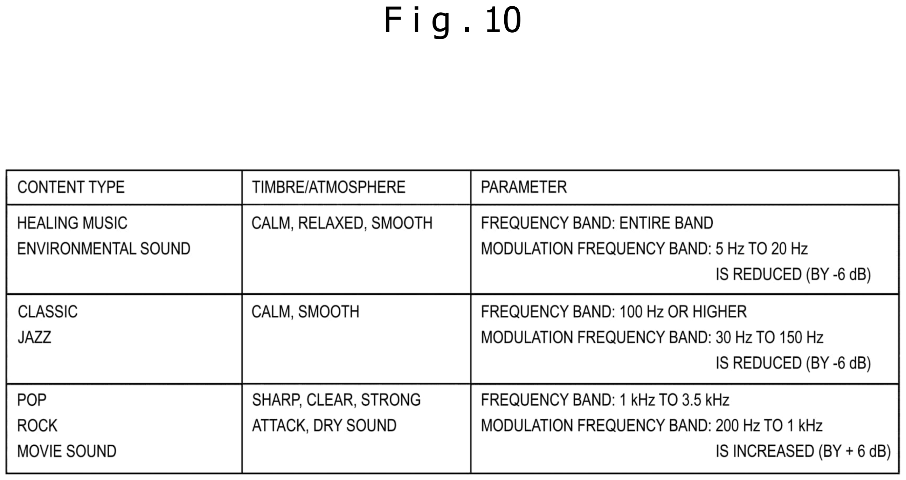

For example, when the content type is healing music, environmental sound, or the like, the type of sound (timbre and atmosphere) only need be calm, relaxed, or smooth as illustrated in Fig. 10. As a parameter corresponding to this, a parameter for reducing (by - 6 dB) the modulation frequency band of 5 to 20 Hz is prepared for the frequency band of the entire band.

In addition, when the content type is classic, jazz, or the like, the type of sound (timbre and atmosphere) only need be calm and smooth. As a parameter corresponding to this, a parameter for reducing (by - 6 dB) the modulation frequency band of 30 to 150 Hz is prepared for the frequency band of 100 Hz or higher.

Further, when the content type is pop, rock, movie sound, or the like, the type of sound (timbre and atmosphere) only need be sharp, clear, a sound with a strong attack feeling, a dry sound, or the like. As a parameter corresponding to this, a parameter for increasing (by + 6 dB) the modulation frequency band of 200 to 1 kHz is prepared for the frequency band of 1 k to 3.5 kHz.

Returning to the description of Fig. 9, the envelope synthesis control unit 273 selects a parameter optimal to the content type (category, musical instrument type, timbre, etc.) obtained by the content type acquisition unit 271 from among parameters prepared in advance as the preset synthesis parameter 272. The selected parameter is supplied to the envelope weighting unit 252 as weight information.

Detailed Configuration of Envelope Weighting Unit

Here, a detailed configuration of the envelope weighting unit 252 will be further described.

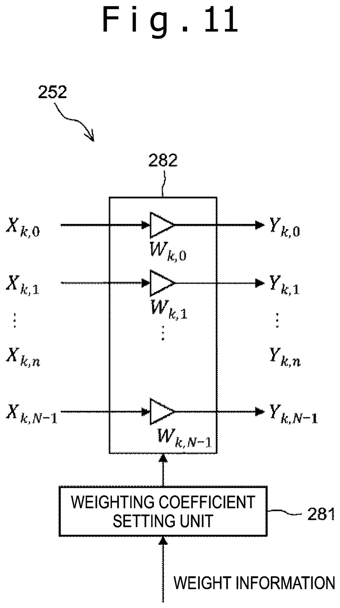

Fig. 11 is a block diagram illustrating a configuration example of the envelope weighting unit 252.

A weighting coefficient setting unit 281 sets a weighting coefficient for each envelope spectral coefficient based on the weight information from the synthesis parameter determination unit 230. The weighting unit 282 multiplies N envelope spectral coefficients $X_{k,n}$ (n = 0, 1, ..., N - 1) in band k by weighting coefficients $W_{k,n}$ different for respective frequency bins, thereby outputting N weighted envelope spectral coefficients $Y_{k,n}$ (n = 0, 1, ..., N - 1).

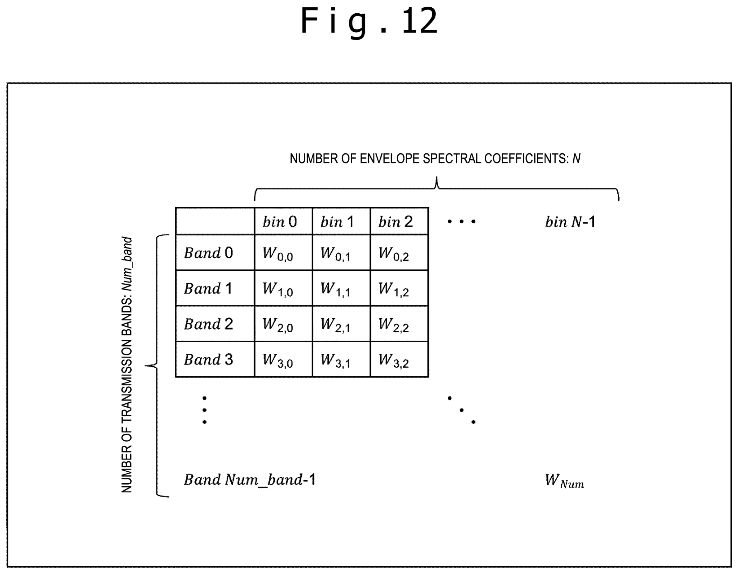

Since the above-described processing is performed for all bands k, the weight information from the synthesis parameter determination unit 230 is a two-dimensional table as illustrated in Fig. 12. The weight information illustrated in Fig. 12 is a table having Num_band rows and N columns. As described above, Num_band represents the number of transmitted bands.

Note that, although the envelope spectral coefficients are multiplied by simple weighting coefficients $W_{k,n}$ in this example, processing of the weighted sum of N envelope spectral coefficients may be performed. That is, for band k, N × N weighting coefficients $W_{k,n,m}$ are used to perform the processing below.

$$Y_{k,n} = \Sigma m [W_{k,n,m} \times X_{k,n}] \quad (n, m = 0, 1, ..., N - 1)$$

Further, a neural network may be used for the weighting processing on the envelope spectral coefficients.

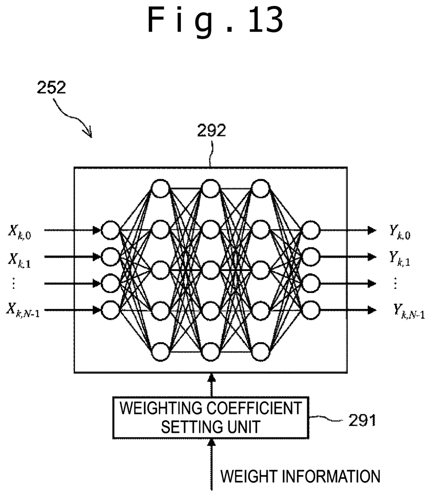

Fig. 13 is a block diagram illustrating another configuration example of the envelope weighting unit 252.

A weighting coefficient setting unit 291 sets a weighting coefficient of a network unit 292 based on the weight information from the synthesis parameter determination unit 230. The network unit 292 performs a weighting processing using a neural network on N envelope spectral coefficients $X_{k,n}$ (n = 0, 1, ..., N - 1) in band k, thereby outputting N weighted envelope spectral coefficients $Y_{k,n}$ (n = 0, 1, ..., N - 1).

The parameters of the neural network are learned using, as a reference signal, a signal of a sound source manually edited to have desired timbre and a desired sound atmosphere.

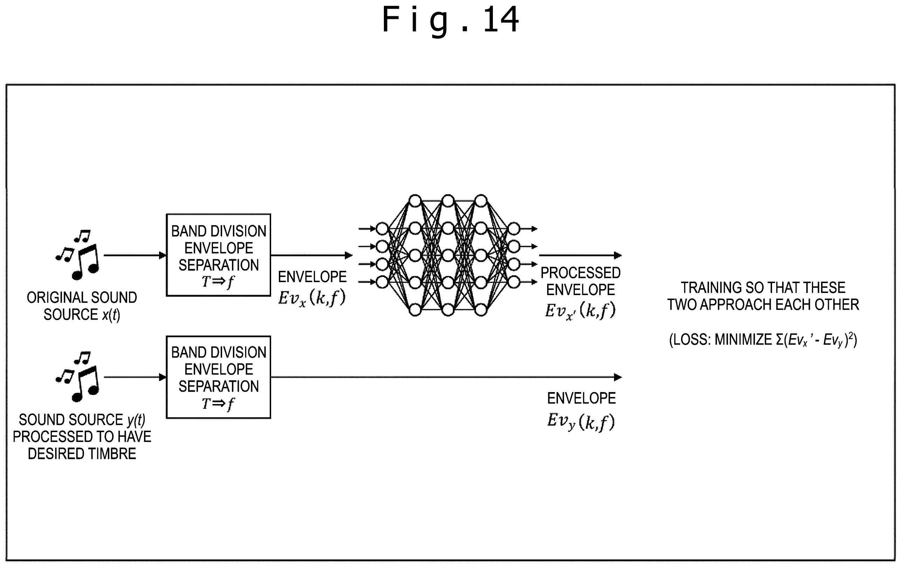

For example, the parameters can be learned in the flow as illustrated in Fig. 14. First, a signal x (t) of the sound source to be processed is subjected to band-division and envelope separation according to a configuration similar to that of the encoding device 100 in Fig. 3, thereby acquiring an envelope component $Ev_x$ (k, f) (k represents an index of a band, and f represents an index of an envelope spectral coefficient). The envelope component $Ev_x$ (k, f) is input to a network such as a deep neural network (DNN), and the obtained output is denoted by $Ev_{x'}$ (k, f). The network configuration here may be any configuration.

On the other hand, an envelope component acquired by similarly performing band-division and envelope separation on a signal y(t) of a reference sound source having desired timbre is denoted by $Ev_y$ (k, f).

Then, the parameters of the network are learned so that the above-described network output $Ev_{x'}$ (k, f) and the envelope component $Ev_y$ (k, f) of the reference sound source become as close as possible. For example, the mean square errors (MSE) of both components are minimized as a loss function.

In addition, a generative adversarial network (GAN) using a discriminator that discriminates whether an input signal is a signal of the reference sound source or a signal generated by a network (generator) may be used together. In addition to the above-described learning method, reinforced learning, unsupervised learning, or the like may be used.

Operation of Decoding Device

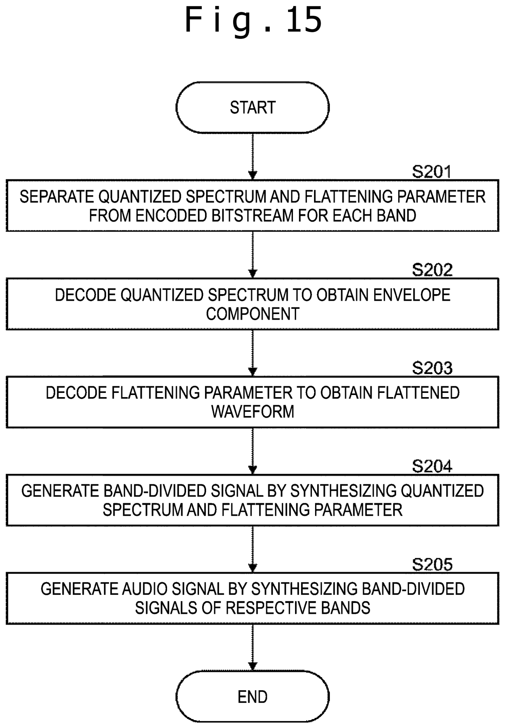

Next, the flow of a decoding processing of an audio signal by the decoding device 200 will be described with reference to the flowchart of Fig. 15. In Fig. 15, the flow of the decoding processing for the band of which isEnvelope-Spectral is True will be mainly described, but the decoding processing for the band of which isEnvelopeSpectral is False is also performed in parallel.

In step S201, the decoding/demultiplexing unit 210 separates the quantized spectrum and the flattening parameter for each band from the encoded bitstream of the audio signal input to the decoding device 200.

In step S202, the band decoding unit 220A (the inverse quantization unit 251, the envelope weighting unit 252, and the inverse frequency transform unit 253) decodes the quantized spectrum separated from the encoded bitstream to acquire the envelope component. Specifically, the inverse quantization unit 251 inversely quantizes the quantized spectrum to obtain the envelope spectral coefficient, the envelope weighting unit 252 performs a weighting processing on the envelope spectral coefficient, and the inverse frequency transform unit 253 inversely transforms the weighted envelope spectral coefficient into the envelope component through inverse frequency transform.

In step S203, the band decoding unit 220A (flattened waveform generation unit 254) decodes the flattening parameter separated from the encoded bitstream to acquire the flattened waveform.

In step S204, the band decoding unit 220A (envelope synthesis unit 255) generates a band-divided signal by synthesizing the envelope component and the flattened waveform.

Then, in step S205, the band synthesis unit 240 generates an audio signal by synthesizing the band-divided signals of the respective bands.

According to the above configuration and processing, since the encoded bitstream in which an envelope component important for timbre and a sound atmosphere is encoded through frequency transform with high accuracy and a component other than the envelope component is encoded with a smaller number of bits is decoded, the reconstruction can be performed without losing the original timbre and sound atmosphere, and further the sense of presence even if it is transmitted with a small amount of information. That is, it is possible to maintain good sound quality even at a low bit rate.

6. Variation of Decoding Device

A variation of the above-described decoding device 200 will be described.

Weighting of Envelope Component after Inverse Frequency Transform

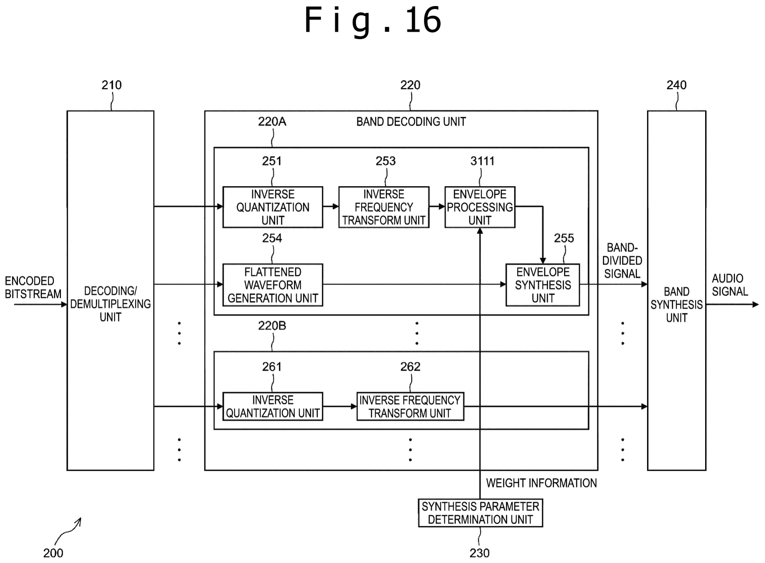

Fig. 16 is a block diagram illustrating another functional configuration example of the decoding device 200.

The decoding device 200 of Fig. 16 differs from the decoding device 200 of Fig. 8 in that the envelope weighting unit 252 is not provided in the band decoding unit 220A, and an envelope processing unit 311 is newly provided between the inverse frequency transform unit 253 and the envelope synthesis unit 255.

That is, the decoding device 200 (band decoding unit 220A) in Fig. 16 does not directly perform a weighting processing on N envelope spectral coefficients obtained by decoding and inverse quantization, but converts the envelope spectral coefficients into envelope components through inverse frequency transform, and then the envelope processing unit 311 performs a weighting processing on the envelope components in a desired (specific) frequency range. In this way, the envelope processing unit 311 also performs a weighting processing related to the envelope spectral coefficient of each band based on the weight information supplied from the synthesis parameter determination unit 230.

In this case, it is possible to perform processing of the modulation frequency component more suitable for the human auditory characteristics without depending on the number of divisions of the band-division filter such as MDCT and the restriction of the bandwidth. For example, the envelope component is non-equally divided using a constant Q filter bank imitating a "modulated filter bank", and then some of the divided signals can be processed, the "modulated filter bank" being disclosed in "Modeling auditory processing of amplitude modulation. I. Detection and masking with narrow-band carriers" by Dau, T et al in the Journal of the Acoustical Society of America vol. 102,5 Pt 1 (1997): 2892-905. Note that, when the signal input to the encoding device 100 is a video signal or a tactile signal, processing suitable for the visual characteristics or tactile characteristics of a human may be performed on the decoding device 200 side.

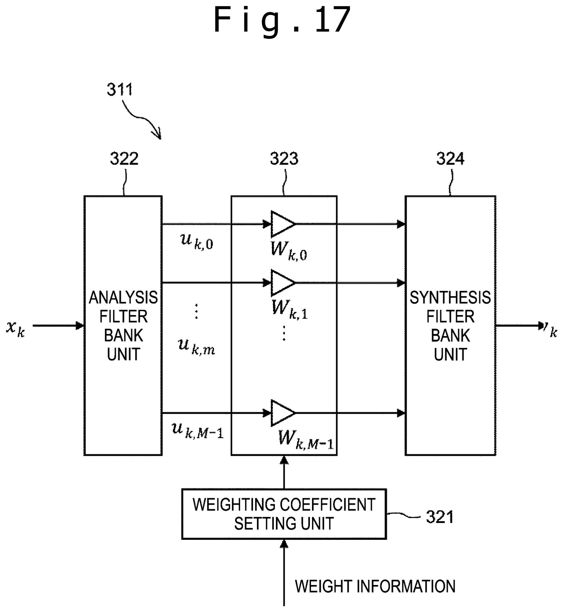

Fig. 17 is a block diagram illustrating a configuration example of the envelope processing unit 311.

The weighting coefficient setting unit 321 sets a weighting coefficient of each band based on the weight information from the synthesis parameter determination unit 230. An analysis filter bank unit 322 divides the envelope component $x_k$ of band k into M band signals $u_{k,m}$ (m = 0, 1, ..., M - 1). The weighting unit 323 multiplies M band signals $u_{k,m}$ in band k by weighting coefficients $w_{k,m}$ for respective divided bands. The synthesis filter bank 324 unit outputs the processed envelope component $y_k$ by re-synthesizing the weighted M band signals $u_{k,m}$.

Note that the operations of the envelope processing unit 311 and the envelope weighting unit 252 in Fig. 8 described above are based on the premise that the band is envelope-separated (isEnvelopeSpectral is True). That is, since the decoding device 200 cannot apply the envelope processing to a band that is not envelope-separated, it is desirable that the encoding device 100 performs envelope separation on a band whose envelope component may be processed during decoding.

In this case, for a band that is not envelope-separated (isEnvelopeSpectral is False), information about the band out of the weight information from the synthesis parameter determination unit 230 is disregarded.

When an envelope component of a band that is not envelope-separated is processed, the envelope component may be processed after envelope separation, as in the processing of the encoding device 100. To be more specific, it is only necessary that, with the envelope separation unit 161 or the frequency transform unit 162 in Fig. 3 being provided in the subsequent stage of the band decoding unit 220B (the inverse frequency transform unit 262), the envelope components (envelope spectral coefficients) and the flattened waveform are acquired, processed by the envelope weighting unit 252 (Fig. 8) or the envelope processing unit 311 (Fig. 16), and then re-synthesized and output by the envelope synthesis unit 255.

Variation of Synthesis Parameter Determination Unit

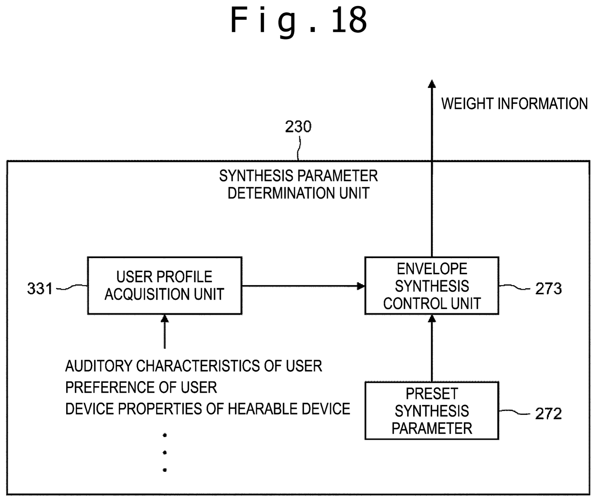

Fig. 18 is a block diagram illustrating another configuration example of the synthesis parameter determination unit 230 included in the decoding device 200.

The synthesis parameter determination unit 230 of Fig. 18 is different from the synthesis parameter determination unit 230 of Fig. 9 in that a user profile acquisition unit 331 is provided, instead of the content type acquisition unit 271.

The user profile acquisition unit 331 acquires, as profile information of a user viewing the content, auditory characteristics of the user, preferences of the user, device properties of a hearable device worn by the user, and the like.

For example, the user profile acquisition unit 331 acquires a user's favorite timbre, device properties of earphones being used, and, if the user is a hearing-impaired person, auditory characteristics thereof, device properties of a hearing aid, and the like from a user profile recorded in advance, and outputs the acquired information as profile information to the envelope synthesis control unit 273. Further, the user profile recorded in advance may be updated by being individually optimized for each user, or new data may be added.

The envelope synthesis control unit 273 determines the weight information by selecting a parameter optimal to the profile information from the user profile acquisition unit 331 from among parameters prepared in advance as the preset synthesis parameters 272. A parameter of each band is prepared as the preset synthesis parameter 272 so as to obtain an optimum sound in accordance with the user's preferred timbre, the auditory characteristics (particularly in a case of a hearing-impaired person), the characteristics of the device to be used, and the like.

For example, regardless of whether a user prefers timbre with small roughness, when the sensitivity of a modulation frequency band related to the roughness is increased due to the properties of a device used by the user and the sound is heard roughly, the timbre can be improved by decreasing the intensity of the modulation frequency component of the band.

In addition, based on the findings disclosed in "Measurement of Temporal Resolution in Presbyacusis" by Okamoto Yasuhide, Kanzaki Akira, Nukano Ayako, Nakaichi Kenji, Morimoto Ryuji, Harada Kouta, Kubota Eri, and Ogawa Iku, in AUDIOLGY JAPAN, 2014, Vol. 57, No. 6, pp. 694-702, which indicate that elderly people with presbycusis tend to have higher modulation thresholds in Temporal Modulation Transfer Function (TMTF) compared to normal hearing individuals, by enhancing the intensity of the modulation frequency components that have higher modulation thresholds relative to normal hearing, the difficulty in perceiving voices and music caused by hearing loss can be mitigated.

Further, for users who have difficulty understanding speech due to hearing loss, based on the finding disclosed in "Effect of reducing slow temporal modulations on speech reception" by Drullman, R et al. in The Journal of the Acoustical Society of America, Vol. 95, No. 5, Pt. 1 (1994): 2670-80, indicating "the modulation frequency of the amplitude envelope of speech is 8 to 10 Hz", the corresponding envelope spectral coefficients may be increased. To be more specific, for the frequency band at around 100 to 2000 Hz (frequency band corresponding to human voices), the envelope spectrum corresponding to the modulation frequency band of 8 to 10 Hz may be increased by + 6 dB, for example.

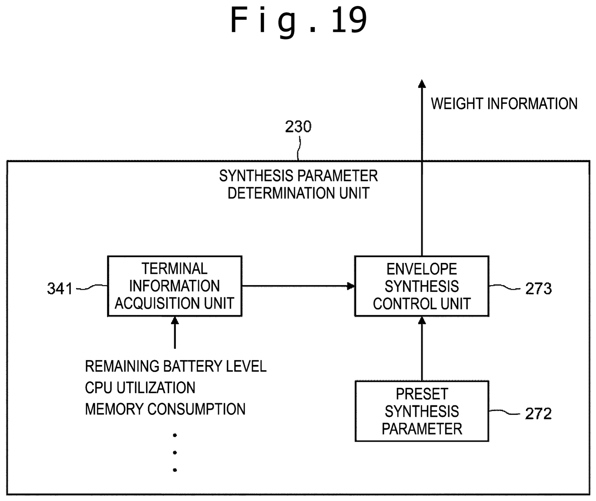

Fig. 19 is a block diagram illustrating another configuration example of the synthesis parameter determination unit 230 included in the decoding device 200.

The synthesis parameter determination unit 230 of Fig. 19 is different from the synthesis parameter determination unit 230 of Fig. 9 in that a terminal information acquisition unit 341 is provided, instead of the content type acquisition unit 271.

The terminal information acquisition unit 341 acquires terminal information of a reproduction terminal (the decoding device 200), a transmission status (a network status) of a network on which an encoded bitstream is transmitted, and the like.

For example, the terminal information acquisition unit 341 acquires the processing resources and loading status of the own device, such as the remaining battery level, the CPU utilization, and the memory consumption (rate) of the decoding device 200, and outputs the processing resources and loading status to the envelope synthesis control unit 273 as the terminal information.

The envelope synthesis control unit 273 determines the weight information by selecting a parameter optimal to the terminal information from the terminal information acquisition unit 341 from among parameters prepared in advance as the preset synthesis parameters 272.

When the remaining battery level or the processing resources of the reproduction terminal are insufficient, by disregarding the envelope spectral coefficients that do not affect the main timbre so much, it is possible to omit part of the arithmetic processing in the inverse frequency transform unit 253 and the envelope synthesis unit 255 in the subsequent stage of the envelope weighting unit 252. As an example of further reduction in the amount of processing, by disregarding 1/2 or 3/4 of the envelope spectral coefficients on the high frequency band side as described above, the transform size of the inverse frequency transform such as the inverse MDCT is reduced to 1/2 or 1/4 of the original size to perform transformation, allowing the transform into the down-sampled envelope components to be performed with a smaller amount of calculation. In this case, the envelope synthesis unit 255 may perform the envelope synthesizing processing on the down-sampled envelope components as they are.

In addition, when the network status is bad and there is a strange abnormal sound due to packet loss or a transmission error, it is also possible to transform the abnormal sound into timbre that is not so annoying by using an appropriate preset parameter. For example, by transforming a sound into a sound with timbre having an attack feeling or coarseness like rock music, noise is not noticeable.

Further, the envelope synthesis control unit 273 may control the band decoding unit 220A and the band synthesis unit 240 for each band based on the terminal information. When the processing load is very high, the processing load can be significantly reduced by not performing all of the decoding processing and the synthesis processing of the predetermined high frequency band that has undergone band-division. Alternatively, the encoding device 100 may be notified of the load status of the reproduction terminal, and the server may switch the band for encoding and transmission according to the load status of the reproduction terminal. In this case, the network status detection unit 140 (Fig. 3) only needs to receive and detect the load status of the reproduction terminal.

Configuration for Decoding Audio Object Encoded Data

The decoding device 200 may decode audio object encoded data including audio object data and metadata of an audio object as an encoded bitstream.

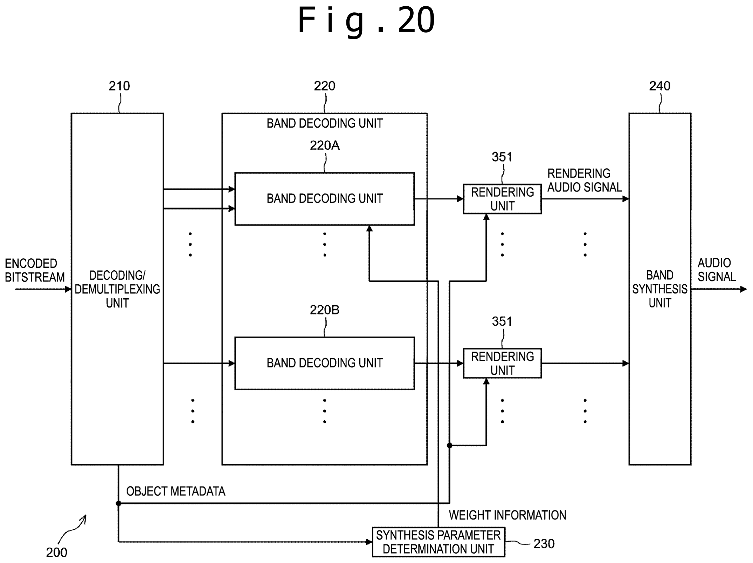

Fig. 20 is a block diagram illustrating yet another functional configuration example of the decoding device 200.

The decoding device 200 of Fig. 20 differs from the decoding devices 200 of Figs. 8 and 16 in that a rendering unit 351 is newly provided in the subsequent stage of each of the band decoding units 220A and 220B provided for each band. Note that, in the decoding device 200 of Fig. 20, the same components as those of the decoding devices 200 of Fig. 8 and 16 are denoted by the same reference numerals, and the description thereof will be basically omitted.

However, the decoding/demultiplexing unit 210 decodes the audio object data and the object metadata from the encoded bitstream in addition to the above-described function. The object metadata is supplied to the rendering unit 351 and used for rendering, and is also supplied to the synthesis parameter determination unit 230.

The rendering unit 351 is provided for each band resulting from the band division, performs rendering processing on an audio object for each frequency band, and outputs a rendering audio signal rendered into a multi-channel signal. The rendering audio signals of the respective bands are synthesized by the band synthesis unit 240, and time waveform signals of the respective channels are obtained.

Further, the content type acquisition unit 271 (Fig. 9) of the synthesis parameter determination unit 230 acquires object information of the audio object from the object metadata decoded by the decoding/demultiplexing unit 210. The object information includes the content category (attribute information) to which the audio object belongs, the sound type (musical instrument, vocal, environmental sound, or the like), the musical instrument type, timbre information (parameters of timbre elements such as timbre type, roughness, and sharpness), object priority (priority information), spread degree of the audio object (spread information), and the like.

The envelope synthesis control unit 273 (Fig. 9) of the synthesis parameter determination unit 230 determines the weight information by selecting the optimal preset parameter based on the object information acquired by the content type acquisition unit 271. Since the audio object is usually classified by musical instrument and sound type, a parameter that provides an optimal timbre is selected according to the category, sound type, musical instrument type, and the like included in the object information. In addition, when the object metadata includes timbre information (parameters of timbre elements such as timbre type, roughness, and sharpness), a parameter set close to each timbre element is selected according to the timbre information.

Further, the parameter set may be selected according to the object priority. For example, when the object priority is high, it is considered that the influence on the entire reproduced sound is significant, and thus a parameter set that particularly emphasizes a timbre component according to the type or category of the sound of the audio object is selected.

Conversely, when the object priority is low, only the envelope component important for the category is left, and the other envelope components are set to zero, thereby further reducing the processing load during decoding.

In this way, the optimal parameter is selected based on the object information and output as the weight information.

In object encoding, signals of sound sources such as musical instruments and vocals at the same position are encoded as audio objects for each sound source. Reverberation, cheers of spectators, and the like without a clear position of the sound sources can be expressed by some virtual objects. In a case where the object encoded data is decoded and reproduced, the rendering unit 351 decodes the audio signals of the plurality of audio objects included in the encoded bitstream to restore time waveform signals. Thereafter, the rendering unit 351 maps the sound in a three-dimensional space based on the position information, the gain information, and the like of the audio object included in the object metadata, and maps the sound to a plurality of channel signals in accordance with the reproduction environment (rendering processing).

For example, in a case of speaker reproduction, the spatial position of a sound image is reproduced by a method called Vector-based Amplitude Panning (VBAP) in accordance with the arrangement and the number of speakers, and the audio signal of each audio object is mapped to each channel signal based on the position information of the audio object included in the object metadata. In a case of headphone reproduction, a reverberation impulse response of a room such as a so-called head-related transfer function (HRTF) or a room impulse response (RIR) is applied so that a sound image is localized at the position of each audio object when the audio object is viewed, and a stereoscopic sound is generated (also referred to as a virtualizer). Further, Binaural Room Impulse Response (BRIR), Higher Order Ambisonics (HOA), or the like may be used for the rendering processing.

Normally, such rendering processing is performed after all the audio waveforms of the necessary audio objects are decoded. That is, it is necessary to provide the decoding device 200 for each audio object or to perform the rendering processing after repeating the decoding processing as many times as the number of audio objects. Further, different rendering processing may be required for different frequency bands. For example, in a case of speakers, since the characteristics and appropriate arrangement of devices such as a woofer, a midrange, and a tweeter are different in each frequency band, it is desirable to perform different rendering processing for each frequency band (the same applies to headphones).

As described above, since the processing load of the decoding processing and the rendering processing of the audio object is large, the decoding device 200 of Fig. 20 performs the rendering processing for each band in the previous stage of the band synthesis unit 240. With this configuration, when rendering processing is performed differently for each frequency, it is not necessary to perform band-division processing again in the subsequent stage, and thus the amount of processing can be reduced.

Note that, in the example of Fig. 20, the rendering unit 351 is provided in the subsequent stage of the band decoding units 220A and 220B for each band. While not limited thereto, the rendering unit 351 may be provided between the inverse frequency transform unit 253 and the envelope synthesis unit 255 inside the band decoding unit 220A (Fig. 8), considering that the envelope components greatly contribute to the perceived localization of a sound image. Further, the rendering unit 351 may be provided in a stage preceding the inverse frequency transform units 253 and 262, and the rendering processing (multiplication by a gain different for each frequency) may be performed on the envelope spectral coefficient (frequency spectral coefficient) in the frequency domain.

Note that, with respect to the flattened waveform, it is considered that the contribution of the flattened waveform to the perceived localization of the sound image is not significant (particularly in the low frequency range). Therefore, the rendering processing may be performed by a simple method of adding the flattened waveform of each object without change and mixing down the added flattened waveform into each channel signal, or performing gain adjustment such as VBAP on a gain parameter when the flattened waveform is parameter-encoded.

7. Variation of Encoding Device and Music

Production/Editing Tool

Variation of Encoding Device

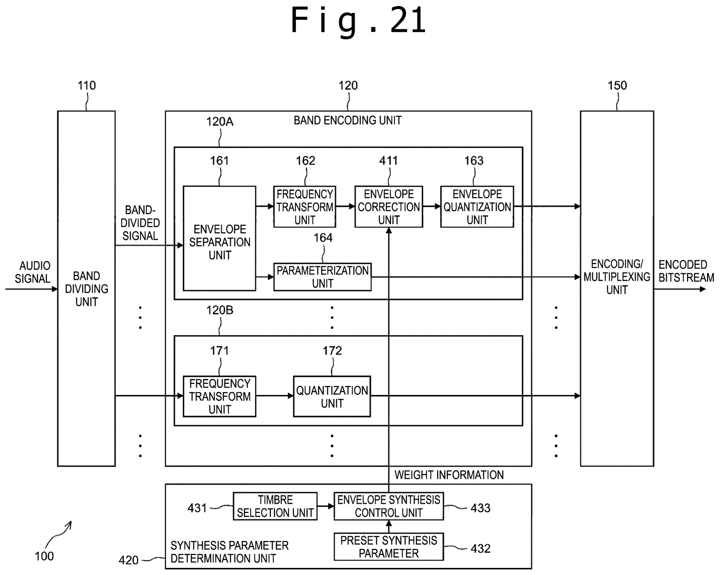

Fig. 21 is a block diagram illustrating another functional configuration example of the encoding device 100.

The encoding device 100 of Fig. 21 is different from the encoding device 100 of Fig. 3 in that an envelope correction unit 411 is provided between the frequency transform unit 162 and the envelope quantization unit 163 in the band encoding unit 120A, and a synthesis parameter determination unit 420 is newly provided. Note that, in the encoding device 100 of Fig. 21, the same components as those of the encoding device 100 of Fig. 3 are denoted by the same reference numerals, and the description thereof will be basically omitted. In addition, in Fig. 21, the content type acquisition unit 130 and the network status detection unit 140 included in the encoding device 100 of Fig. 3 are not illustrated.

In this way, the envelope correction unit 411 performs a weighting processing related to the envelope spectral coefficient of each band based on the weight information supplied from the synthesis parameter determination unit 420. Specifically, the envelope correction unit 411 acquires the weighted envelope spectral coefficient by multiplying the envelope spectral coefficient from the frequency transform unit 162 by a weighting coefficient different for each frequency bin based on the weight information from the synthesis parameter determination unit 420. The obtained weighted envelope spectral coefficient is supplied to the envelope quantization unit 163.

The synthesis parameter determination unit 420 includes a timbre selection unit 431, a preset synthesis parameter 432, and an envelope synthesis control unit 433.

Note that the preset synthesis parameter 432 and the envelope synthesis control unit 433 have basically the same functions as the preset synthesis parameter 272 and the envelope synthesis control unit 273 included in the synthesis parameter determination unit 230 in Fig. 9 and the like, respectively.

The timbre selection unit 431 acquires timbre information of the content in accordance with an input from a predetermined graphical user interface (GUI), and outputs the acquired timbre information to the envelope synthesis control unit 433.

The envelope synthesis control unit 433 selects a parameter optimal to the timbre information from the timbre selection unit 431 from among parameters prepared in advance as the preset synthesis parameters 432.

The encoding device 100 of Fig. 21 configured as described above has two types of operation modes, namely, an editing mode and an archive mode, as operation modes.

The editing mode is used when the encoding device 100 is called from an editing screen (GUI) of a music production/editing tool described below and an editor converts a desired signal waveform into desired timbre.

In the editing mode, the envelope correction unit 411 multiplies each component of the envelope spectral coefficient from the frequency transform unit 162 by a weighting coefficient based on the weight information from the synthesis parameter determination unit 420, and outputs a weighted envelope spectral coefficient.

On the other hand, the timbre selection unit 431 of the synthesis parameter determination unit 420 acquires the timbre type of the content input from the editing screen and supplies the acquired timbre type to the envelope synthesis control unit 433. The envelope synthesis control unit 433 selects a parameter optimal to the timbre information from among the preset synthesis parameters 432 prepared in advance according to the timbre information from the timbre selection unit 431, and outputs the selected parameter as weight information.

In this way, the encoding device 100 of Fig. 21 can transform a desired signal into a sound with desired timbre or atmosphere during encoding.

The archive mode is used, for example, when automatic archival processing is performed for a content. In a signal of a content to be archived, an envelope component (modulation frequency component) important for the timbre being abnormally strong or changing rapidly causes a sound with a sense of discomfort even if clipping or the like is not performed. Therefore, during archival processing, an abnormality of the envelope component that affects the timbre is detected, and if an abnormality is detected, the envelope component is corrected to an envelope component with optimal timbre.

In the archive mode, the envelope correction unit 411 determines whether the envelope spectral coefficient from the frequency transform unit 162 is within a predetermined range. When the envelope spectral coefficient exceeds a predetermined threshold value or is not within the range, the envelope correction unit 411 corrects the envelope spectral coefficient to an optimal coefficient by multiplying the envelope spectral coefficient by a predetermined weighting coefficient based on the parameter of the weight information from the synthesis parameter determination unit 420, and outputs the corrected coefficient as a weighted envelope spectral coefficient. The weighted envelope spectral coefficient is supplied to the envelope quantization unit 163, and the same processing as that of the encoding device 100 of Fig. 3 is performed thereafter.

On the other hand, the timbre selection unit 431 of the synthesis parameter determination unit 420 acquires the timbre type of the content that is manually input or automatically detected from the audio signal, and supplies the acquired timbre type to the envelope synthesis control unit 433. The envelope synthesis control unit 433 selects a parameter optimal to the timbre information from among the preset synthesis parameters 432 prepared in advance according to the timbre information from the timbre selection unit 431, and outputs the selected parameter as weight information.

In this manner, according to the encoding device 100 of Fig. 21, during the archival processing, an abnormality of the envelope component that affects the timbre is detected simultaneously with encoding, and if there is an abnormality, the envelope component can be corrected to an envelope component with the optimal timbre.

Editing Screen of Music Production/Editing Tool

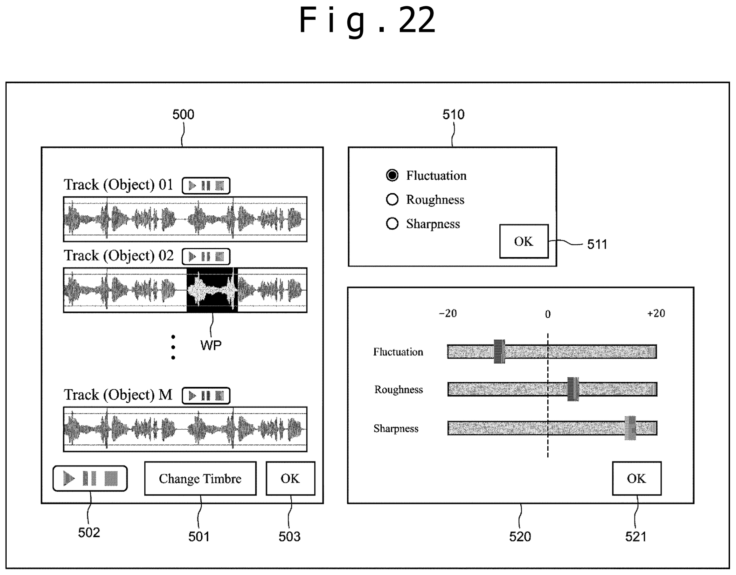

Fig. 22 is a diagram illustrating an example of an editing screen of the above-described music production/editing tool.

The music production/editing tool includes the encoding device 100 of Fig. 21, and corrects or transforms timbre of selected signal waveforms.

In Fig. 22, a main editing screen 500 on the left side is a screen for displaying a signal waveform of each track or each object of audio data being edited. When an editor selects a predetermined waveform portion WP in the track (object) 02, for example, as a track (object) to be edited and presses the Change Timbre button 501, a timbre selection dialog 510 in the upper right of the figure is displayed.

In the timbre selection dialog 510, the editor selects desired timbre to be emphasized or reduced. Here, as the timbre, fluctuation, sharpness, or roughness can be selected.

Further, instead of the timbre selection dialog 510, a timbre processing dialog 520 at the lower right in the figure may be displayed. In this case, the editor can adjust the strength of above-described fluctuation, sharpness, and roughness with the slider. The strength of each item has a plus direction and a minus direction, and when the strength is 0, the corresponding timbre does not change.

When the OK button 511 is pressed in the timbre selection dialog 510 or the OK button 521 is pressed in the timbre processing dialog 520, the focus is returned to the main editing screen 500. In the main editing screen 500, the selected waveform portion WP of the audio data is processed so as to emphasize or reduce the timbre selected and adjusted in the timbre selection dialog 510 or the timbre processing dialog 520.

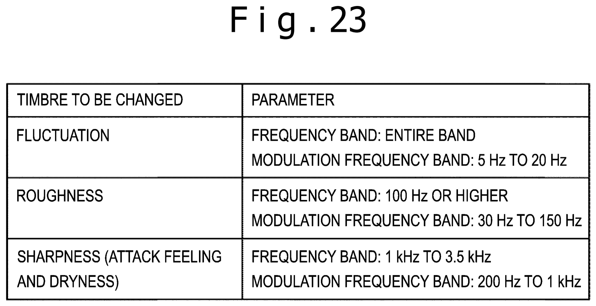

That is, in the encoding device 100 of Fig. 21, for the selected timbre, a parameter corresponding to the timbre and content is acquired from the preset synthesis parameters 432, and the envelope correction unit 411 corrects and processes the timbre by changing the weighting coefficient of the envelope component (the processing method of the envelope spectral coefficient) using the parameter. Note that when the strength is 0, the corresponding envelope spectral coefficient is not processed. Although the range of envelope spectral coefficients processed in accordance with the selected timbre is not defined, the corresponding frequency band and modulation frequency band are illustrated in Fig. 23.

As illustrated in Fig. 23, when fluctuation is desired to be changed, the envelope spectral coefficients corresponding to the modulation frequency band of 5 to 20 Hz only need be processed based on the strength adjusted in the timbre processing dialog 520 for the frequency bands of the entire band.

In addition, when fluctuation is desired to be changed, the envelope spectral coefficients corresponding to the modulation frequency band of 30 to 150 Hz only need be processed based on the strength adjusted in the timbre processing dialog 520, for the frequency band of 100 Hz or higher.

Further, when sharpness is desired to be changed, the envelope spectral coefficients corresponding to the modulation frequency band of 200 to 1 kHz only need be processed based on the strength adjusted in the timbre processing dialog 520 for the frequency band of 1 k to 3.5 kHz.

When the above processing is completed, the editor confirms the processed audio data by pressing the reproduction button 502, and the processed audio data is stored by pressing the OK button 503.

8. Summary

According to the encoding device 100 (Fig. 1) of the present disclosure, an audio signal is separated into an envelope component and a component other than the envelope component, the envelope component important for timbre and the atmosphere of the sound is frequency-transformed and encoded with high accuracy, and the component other than the envelope component is encoded with a smaller number of bits, and thus, the reconstruction can be performed without losing the original atmosphere, timbre, and sense of presence of the sound even if it is transmitted with a small amount of information.

Furthermore, since a large number of bits are allocated to quantization of the envelope component important for reproduction of the timbre in accordance with the timbre and the atmosphere of the sound corresponding to the category of the sound, the signal can be reproduced to have the timbre optimal for the category of the sound even if it is transmitted with a small amount of information.

Further, according to the encoding device 100 (Fig. 1), the transmission format (Fig. 6), and the decoding device 200 (Fig. 8) of the present disclosure, since the configuration is dynamically switched for each band between a configuration in which the band-divided signal is divided into an envelope component and a component other than the envelope component and encoded and a configuration in which the envelope components are not separated and directly frequency-transformed and encoded, it is possible to reproduce the envelope component of the band important for reproduction of the timbre while suppressing the processing load in accordance with the situation such as the processing load of the reproduction terminal, and to reproduce the signal to have the optimal timbre.

According to the decoding device (Figs. 8, 16, and 20) of the present disclosure, it is possible to easily change the timbre and the atmosphere of the sound of the audio signal to have desired characteristics during reproduction. In particular, the content can be reproduced to have optimal timbre according to the type of the content such as video and audio. Further, even when the transmission status of the network is poor or the processing load of the reproduction terminal is large, the sound can be heard with an optimal timbre with less sound interruption and less sound quality deterioration. Further, it is possible to dynamically switch to the timbre optimal for the hearing loss characteristics and the viewing/hearing device of the user.

Further, by using a trained neural network for the processing of multiplying an envelope component by a weighting coefficient, transform into an audio signal closer to the desired timbre can be facilitated without tuning the weighting coefficient of the timbre transform.

According to the encoding device 100 (Fig. 21) and the editing screen of the music production/editing tool (Fig. 22) of the present disclosure, transform into a sound having desired timbre and atmosphere can be effectively facilitated during music production or editing, thus making it possible to reduce the time and effort for music content production. Further, since the portion causing an abnormal sound or an uncomfortable feeling can be automatically detected and corrected to have the optimum timbre during the archival processing, labor for archiving can be reduced and the quality of the archived content can be improved.

9. Configuration Example of Computer

The above-described series of pieces of processing can be executed by hardware or software. In a case where the series of pieces of processing is executed by software, a program constituting the software is installed from a program recording medium to a computer embedded in dedicated hardware, a general-purpose personal computer, or the like.

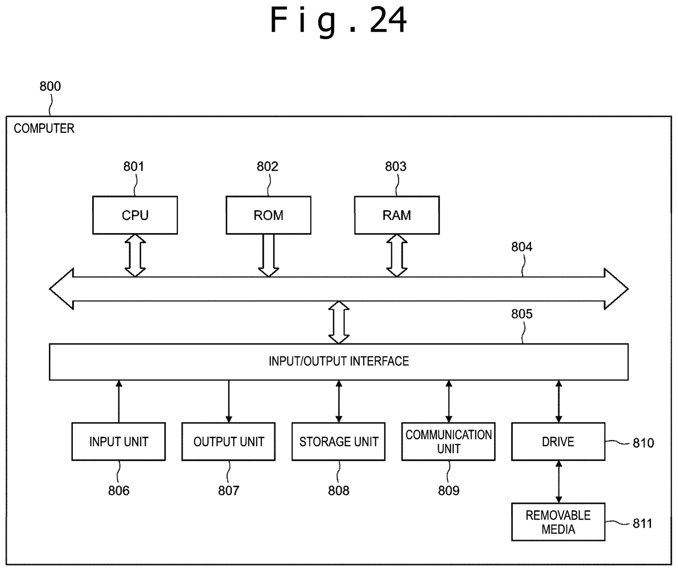

Fig. 24 is a block diagram illustrating a configuration example of hardware for a computer that executes the above-described series of pieces of processing in a program. The encoding device 100 and the decoding device 200 are configured by, for example, a computer 800 having a configuration similar to the configuration illustrated in Fig. 24.

A CPU 801, a read only memory (ROM) 802, and a random access memory (RAM) 803 are connected to each other via a bus 804.

An input/output interface 805 is also connected to the bus 804. An input unit 806 including a keyboard, a mouse, and the like, and an output unit 807 including a display, a speaker, and the like are connected to the input/output interface 805. In addition, a storage unit 808 including a hard disk, a nonvolatile memory, or the like, a communication unit 809 including a network interface or the like, and a drive 810 that drives a removable medium 811 are connected to the input/output interface 805.

In the computer 800 configured as described above, for example, the CPU 801 loads a program stored in the storage unit 808 into the RAM 803 via the input/output interface 805 and the bus 804 and executes the program, thereby executing the series of pieces of processing described above.

The program executed by the CPU 801 is, for example, recorded on the removable medium 811, or provided via wired or wireless transmission media such as a local area network, the Internet, and digital broadcast, and installed in the storage unit 808.

Note that the program executed by the computer 800 may be a program for executing the processing in time series in the order described in the present specification, or may be a program for executing the processing in parallel or at a necessary timing such as when a call is performed.

Note that in the present specification, the system means a set of a plurality of components (devices, modules (parts), and the like), and it does not matter whether all the components are in the same housing. Therefore, the system refers to both a plurality of devices housed in separate housings and connected via a network, and one device in which a plurality of modules are housed in one housing.

Note that the effects described in the present specification are merely examples and are not limited, and other effects may be produced.

Note that embodiments of the present disclosure are not limited to the above-described embodiments, and various modifications can be made without departing from the gist of the present disclosure.

For example, an embodiment of the present disclosure can adopt a configuration of cloud computing in which a plurality of devices perform processing of one function in a shared and cooperated manner via a network.

Further, each step described in the above-described flowchart can be performed by one apparatus or can be shared and executed by a plurality of apparatuses.

Further, when a single step includes multiple pieces of processing, the multiple pieces of processing included in the single step can be executed by a single device, or can be shared and executed by multiple devices.

The effects described in the present specification are mere examples and are not limiting. There may be other effects.

Furthermore, the technology according to present disclosure can have the following configurations.

(1) A decoding device including:

a demultiplexing unit configured to separate, from an encoded bitstream of a content signal, first encoded data obtained by encoding an envelope component of the content signal through frequency transform and second encoded data obtained by encoding a flattened waveform of the content signal with the number of bits different from the number of bits for the envelope component, for each band;
a band decoding unit configured to generate a band-divided signal by synthesizing the envelope component decoded from the first encoded data and the flattened waveform decoded from the second encoded data; and
a band synthesis unit configured to generate the content signal by synthesizing the band-divided signals of respective bands.

(2) The decoding device described in (1), in which the content signal is at least any of an audio signal, a video signal, and a tactile signal.
(3) The decoding device described in (1),

in which the first encoded data is a frequency spectrum obtained by performing frequency transform on the envelope component, and
the second encoded data is a parameter obtained by performing parameter encoding on the flattened waveform.

(4) The decoding device described in (1) or (2),

in which the demultiplexing unit separates, for each band, third encoded data that is a frequency spectrum obtained by performing frequency transform on the band-divided signal from the encoded bitstream, and
the band decoding unit outputs the band-divided signal decoded from the third encoded data.

(5) The decoding device described in (4), in which the demultiplexing unit determines whether to separate the first encoded data and the second encoded data or to separate only the third encoded data for each band in accordance with a flag included in the encoded bitstream.
(6) The decoding device described in any one of (1) to (5), in which the band decoding unit performs weighting processing on the first encoded data of each band.
(7) The decoding device described in (6), in which the band decoding unit multiplies each of frequency bins of the first encoded data of each band by a different weighting coefficient.
(8) The decoding device described in (7), in which the band decoding unit performs the weighting processing using a trained neural network.
(9) The decoding device described in any one of (1) to (5), in which the band decoding unit performs weighting processing on a specific frequency range of the envelope component decoded from the first encoded data of each band.
(10) The decoding device described in (9), in which the band decoding unit multiplies a band signal, obtained by dividing the envelope component by a first filter bank, by a weighting coefficient, and then re-synthesizes the band signal by a second filter bank.
(11) The decoding device described in any one of (1) to (10), further including a weight information determination unit that determines weight information for setting a weighting coefficient in weighting processing related to the first encoded data of each band, by using any of parameters prepared in advance.
(12) The decoding device described in (11), in which the weight information determination unit selects a parameter of the parameters based on at least any of a content type of the content signal, profile information of a user, terminal information of the decoding device, and a status of a network in which the encoded bitstream is transmitted.
(12-1) The decoding device described in (12), in which the content type includes at least any of a program type of a video, category information of a video or music, a musical instrument type, and timbre information.
(12-2) The decoding device described in (12), in which the profile information includes at least any of auditory characteristics of the user, a preference of the user, and device properties of a hearable device worn by the user.
(12-3) The decoding device described in (12), in which the terminal information includes at least any of a remaining battery level, a CPU usage rate, and a memory consumption.
(13) The decoding device described in (11),

in which the encoded bitstream is audio object encoded data including audio object data and metadata of an audio object, and
a rendering unit configured to perform rendering processing for the audio object on the band-divided signal of each band is further included.

(14) The decoding device described in (13), in which the metadata includes at least any of attribute information, position information, and priority information of the audio object.
(15) The decoding device described in (13), in which the rendering processing is rendering processing using at least any of Vector-based Amplitude Panning (VBAP), Head Related Transfer Function (HRTF), Room Impulse Response (RIR), and Higher Order Ambisonics (HOA).

(16) The decoding device described in (13), in which the weight information determination unit selects a parameter of the parameters based on the metadata.

(17) The decoding device described in any one of (13) to (16), in which the rendering unit performs the rendering processing based on the metadata.

(18) A decoding method including:

by a decoding device, separating, from an encoded bitstream of a content signal, first encoded data obtained by encoding an envelope component of the content signal through frequency transform and second encoded data obtained by encoding a flattened waveform of the content signal with the number of bits different from the number of bits for the envelope component, for each band;

by the decoding device, generating a band-divided signal by synthesizing the envelope component decoded from the first encoded data and the flattened waveform decoded from the second encoded data; and

by the decoding device, generating the content signal by synthesizing the band-divided signals of respective bands.

(19) A program causing a computer to perform processing of:

separating, from an encoded bitstream of a content signal, first encoded data obtained by encoding an envelope component of the content signal through frequency transform and second encoded data obtained by encoding a flattened waveform of the content signal with the number of bits different from the number of bits for the envelope component, for each band;

generating a band-divided signal by synthesizing the envelope component decoded from the first encoded data and the flattened waveform decoded from the second encoded data; and

generating the content signal by synthesizing the band-divided signals of respective bands.

(20) An encoding device including:

a band dividing unit that divides a content signal into band-divided signals of respective bands;

a band encoding unit that separates the band-divided signal into an envelope component and a flattened waveform, encodes the envelope component through frequency transform, and encodes the flattened waveform with the number of bits different from the number of bits for the envelope component; and

a multiplexing unit that generates an encoded bitstream by multiplexing first encoded data obtained by encoding the envelope component and second encoded data obtained by encoding the flattened waveform.

(21) The encoding device described in (20),

in which the first encoded data is a frequency spectrum obtained by performing frequency transform on the envelope component, and

the second encoded data is a parameter obtained by performing parameter encoding on the flattened waveform.

(22) The encoding device described in (21), in which the parameter includes any of a predetermined signal waveform pattern and a sine wave parameter.

(23) The encoding device described in (21),

in which the band encoding unit encodes the band-divided signal through frequency transform without change, and

the multiplexing unit generates the encoded bitstream by multiplexing the first encoded data, the second encoded data, and third encoded data that is a frequency spectrum obtained by encoding the band-divided signal through frequency transform.

(24) The encoding device described in (23), in which the band separation unit determines, for each band, an encoding method of whether to encode the band-divided signal after separating the band-divided signal into the envelope component and the flattened waveform, or to encode the band-divided signal without change.

(25) The encoding device described in (23), in which the band separation unit determines the encoding method based on resource information of a reproduction terminal of the content signal or a status of a network in which the encoded bitstream is transmitted.

(26) The encoding device described in (21), in which the band encoding unit quantizes the first encoded data obtained by encoding the envelope component, with the number of quantization bits or a quantization bandwidth according to at least any of a content type of the content signal and a status of a network in which the encoded bitstream is transmitted.

(27) The encoding device described in (26), in which the content type includes at least any of a type of a content, a type of sound of the content, and priority of an audio object.

(28) The encoding device described in (21), in which the band encoding unit performs weighting processing on the first encoded data of each band.

(29) The encoding device described in (28), further including a weight information determination unit that determines weight information for setting a weighting coefficient in the weighting processing by using any of parameters prepared in advance.

(30) The encoding device described in (29), in which the weight information determination unit selects a parameter of the parameters in accordance with an input from a graphical user interface (GUI).

(31) The encoding device described in (28), in which the band encoding unit performs the weighting processing according to a variation of a specific frequency component in the first encoded data of each band.

Reference Signs List

1 Audio signal transmission system, 100 Encoding device, 110 Band separation unit, 120, 120A, 120B Band encoding unit, 130 Content type acquisition unit, 140 Network status detection unit, 150 Encoding/multiplexing unit, 161 Envelope separation unit, 162 Frequency transform unit, 163 Envelope quantization unit, 164 Parameterization unit, 171 Frequency transform unit, 172 Quantization unit. 200 Decoding device, 210 Decoding/demultiplexing unit, 220, 220A, 220B Band decoding unit, 230 Synthesis parameter determination unit, 240 Band synthesis unit, 251 Inverse quantization unit, 252 Envelope weighting unit, 253 Inverse frequency transform unit, 254 Flattened waveform generation unit, 255 Envelope synthesis unit, 261 Inverse quantization unit, 262 Inverse frequency transform unit, 271 Content type acquisition unit, 272 Preset synthesis parameter, 273 Envelope synthesis control unit, 311 Envelope processing unit, 331 User profile acquisition unit, 341, Terminal information acquisition unit, 351 Rendering unit, 411 Envelope correction unit, 420 Synthesis parameter determination unit, 431 Timbre selection unit, 432 Preset synthesis parameter, 433 Envelope synthesis control unit

**Claims**

1. A decoding device comprising:

   a demultiplexing unit configured to separate, from an encoded bitstream of a content signal, first encoded data obtained by encoding an envelope component of the content signal through frequency transform and second encoded data obtained by encoding a flattened waveform of the content signal with the number of bits different from the number of bits for the envelope component, for each band;
   a band decoding unit configured to generate a band-divided signal by synthesizing the envelope component decoded from the first encoded data and the flattened waveform decoded from the second encoded data; and
   a band synthesis unit configured to generate the content signal by synthesizing the band-divided signals of respective bands.

2. The decoding device according to claim 1, wherein the content signal is at least any of an audio signal, a video signal, and a tactile signal.

3. The decoding device according to claim 1,

   wherein the first encoded data is a frequency spectrum obtained by performing frequency transform on the envelope component, and
   the second encoded data is a parameter obtained by performing parameter encoding on the flattened waveform.

4. The decoding device according to claim 1,

   wherein the demultiplexing unit separates, for each band, third encoded data that is a frequency spectrum obtained by performing frequency transform on the band-divided signal from the encoded bitstream, and
   the band decoding unit outputs the band-divided signal decoded from the third encoded data.

5. The decoding device according to claim 4, wherein the demultiplexing unit determines whether to separate the first encoded data and the second encoded data or to separate only the third encoded data for each band in accordance with a flag included in the encoded bitstream.

6. The decoding device according to claim 1, wherein the band decoding unit performs weighting processing on the first encoded data of each band.

7. The decoding device according to claim 6, wherein the band decoding unit multiplies each of frequency bins of the first encoded data of each band by a different weighting coefficient.

8. The decoding device according to claim 7, wherein the band decoding unit performs the weighting processing using a trained neural network.

9. The decoding device according to claim 1, wherein the band decoding unit performs weighting processing on a specific frequency range of the envelope component decoded from the first encoded data of each band.

10. The decoding device according to claim 9, wherein the band decoding unit multiplies a band signal, obtained by dividing the envelope component by a first filter bank, by a weighting coefficient, and then re-synthesizes the band signals by a second filter bank.

11. The decoding device according to claim 1, further comprising a weight information determination unit configured to determine weight information for setting a weighting coefficient in weighting processing related to the first encoded data of each band, by using any of parameters prepared in advance.

12. The decoding device according to claim 11, wherein the weight information determination unit selects a parameter of the parameters based on at least any of a content type of the content signal, profile information of a user, terminal information of the decoding device, and a status of a network in which the encoded bitstream is transmitted.

13. The decoding device according to claim 11,

    wherein the encoded bitstream is audio object encoded data including audio object data and metadata of an audio object, and
    a rendering unit configured to perform rendering processing for the audio object on the band-divided signal of each band is further included.

14. The decoding device according to claim 13, wherein the metadata includes at least any of attribute information, position information, and priority information of the audio object.

15. The decoding device according to claim 13, wherein the rendering processing is rendering processing using at least any of Vector-based Amplitude Panning (VBAP), Head Related Transfer Function (HRTF), Room Impulse Response (RIR), and Higher Order Ambisonics (HOA).

16. The decoding device according to claim 13, wherein the weight information determination unit selects a parameter of the parameters based on the metadata.

17. The decoding device according to claim 13, wherein the rendering unit performs the rendering processing based on the metadata.

18. A decoding method comprising:

    by a decoding device, separating, from an encoded bitstream of a content signal, first encoded data obtained by encoding an envelope component of the content signal through frequency transform and second encoded data obtained by encoding a flattened waveform of the content signal with the number of bits different from the number of bits for the envelope component, for each band;
    by the decoding device, generating a band-divided signal by synthesizing the envelope component decoded from the first encoded data and the flattened waveform decoded from the second encoded data; and
    by the decoding device, generating the content signal by synthesizing the band-divided signals of respective bands.

**19.** A program causing a computer to perform processing of:

separating, from an encoded bitstream of a content signal, first encoded data obtained by encoding an envelope component of the content signal through frequency transform and second encoded data obtained by encoding a flattened waveform of the content signal with the number of bits different from the number of bits for the envelope component, for each band;

generating a band-divided signal by synthesizing the envelope component decoded from the first encoded data and the flattened waveform decoded from the second encoded data; and

generating the content signal by synthesizing the band-divided signals of respective bands.

**20.** An encoding device comprising:

a band dividing unit configured to divide a content signal into band-divided signals of respective bands;

a band encoding unit configured to separate the band-divided signal into an envelope component and a flattened waveform, encode the envelope component through frequency transform, and encode the flattened waveform with the number of bits different from the number of bits for the envelope component; and

a multiplexing unit configured to generate an encoded bitstream by multiplexing first encoded data obtained by encoding the envelope component and second encoded data obtained by encoding the flattened waveform.

# Fig.1

ORIGINAL SOUND SOURCE $x(t)$ → BAND DIVISION ENVELOPE SEPARATION → ENVELOPE → PROCESSING AT 20 Hz OR LOWER → PROCESSED ENVELOPE → ENVELOPE SYNTHESIS BAND SYNTHESIS → FLUCTUATION CHANGES

ALTERNATIVELY, IF | PROCESSING AT 30 TO 150 Hz | ARE APPLIED, → ROUGHNESS CHANGES

PROCESSING AT 200 Hz OR HIGHER → ATTACK FEELING AND SHARPNESS CHANGES

EP 4 742 239 A1

# Fig.2

# Fig. 3

# Fig.4

ENVELOPE COMPONENT

AMPLITUDE

TIME SIGNAL

TIME

ENVELOPE SEPARATION

ENVELOPE COMPONENT

FLATTENED WAVEFORM

EP 4 742 239 A1

# Fig.5

| CONTENT TYPE | TIMBRE/ATMOSPHERE | PARAMETER |
|---|---|---|
| HEALING MUSIC<br>ENVIRONMENTAL SOUND | CALM, RELAXED, SMOOTH | MODULATION FREQUENCY BAND: 5 Hz to 20 Hz<br>QUANTIZATION BANDWIDTH: NARROW<br>NUMBER OF BITS ALLOCATED: LARGE |
| CLASSIC<br>JAZZ | CALM, SMOOTH | MODULATION FREQUENCY BAND: 30 Hz to 150 Hz<br>QUANTIZATION BANDWIDTH: NARROW<br>NUMBER OF BITS ALLOCATED: LARGE |
| POP<br>ROCK<br>MOVIE SOUND | SHARP, CLEAR, STRONG ATTACK,<br>DRY SOUND | MODULATION FREQUENCY BAND: 200 Hz AND HIGHER<br>QUANTIZATION BANDWIDTH: WIDE<br>NUMBER OF BITS ALLOCATED: SMALL |

# Fig.6

| Syntax | Number of bits |
|---|---|
| **Num_band**;    /* Number of transmitted freq. bands */<br>for (k=0; k<Num_band;k++) {<br>    **isEnvelopeSpectral**;<br>    /* Envelope/Direct Spectral */<br>    n=0;<br>    **Num_qu[k]**;    /* Number of quantization bands */<br>    for (q = 0; q < Num_qu[k]; q++) {<br>        **scale_factor_index[k][q]**;<br>        **quant_nbits[k][q]**;    /* Number of bits -1 */<br>        scale_factor = 2^(scale_factor_index[k][q]);<br>        resolution = 2^(quant_bits[k][q] + 1);<br>        for (m=0; m < <u>Num_spec(k, q)</u>; m++){<br>            **code_spec[k][n]**;    /* huffman code for spectral */<br>            q_spec = <u>Huff_decode(code)</u>;<br>            <u>Spec[k][n]</u> = q_spec/resolution * scale_factor ;<br>            n++;<br>        } /* m */<br>    } /* q */<br><br>    if (isEnvelopeSpectral) {<br>        /* Parameter for the flat carrier wave */<br>        **wave_type[k]**;        0:general, 1..3: multitone;<br>        If (wave_type[k] == 0) {<br>            **wave_index[k]**;<br>            **wave_gain [k]**;<br>        }<br>        else {<br>            for (j =0; j< wave_type[k]; j++) {<br>                **tone_freq**;<br>                **tone_gain;**<br>                **tone_phase**;<br>            } /* j */<br>        }<br>    } /* isEnvelopeSpectral */<br>} /* k */ | 4<br><br>1<br><br><br>4<br><br>5<br>3<br><br><br><br>1...8<br><br><br><br><br><br><br><br><br><br>2<br><br>8<br>4<br><br><br><br>4<br>4<br>2 |

# Fig. 7

START

↓ S101

DIVIDE AUDIO SIGNAL INTO BAND-DIVIDED SIGNALS OF RESPECTIVE BANDS

↓ S102

SEPARATE BAND-DIVIDED SIGNAL INTO ENVELOPE COMPONENT AND FLATTENED WAVEFORM

↓ S103

ENCODE ENVELOPE COMPONENT TO OBTAIN QUANTIZED SPECTRUM

↓ S104

ENCODE FLATTENED WAVEFORM TO OBTAIN FLATTENING PARAMETER

↓ S105

GENERATE ENCODED BITSTREAM BY MULTIPLEXING QUANTIZED SPECTRUM AND FLATTENING PARAMETER

↓

END

# Fig.8

210 DECODING/ DEMULTIPLEXING UNIT

ENCODED BITSTREAM

220 BAND DECODING UNIT

220A

251 INVERSE QUANTIZATION UNIT

252 ENVELOPE WEIGHTING UNIT

253 INVERSE FREQUENCY TRANSFORM UNIT

254 FLATTENED WAVEFORM GENERATION UNIT

255 ENVELOPE SYNTHESIS UNIT

220B

261 INVERSE QUANTIZATION UNIT

262 INVERSE FREQUENCY TRANSFORM UNIT

WEIGHT INFORMATION

230 SYNTHESIS PARAMETER DETERMINATION UNIT

240 BAND SYNTHESIS UNIT

AUDIO SIGNAL

200

# Fig. 9

WEIGHT INFORMATION

230

**SYNTHESIS PARAMETER
DETERMINATION UNIT**

271 — CONTENT TYPE
ACQUISITION UNIT

ENVELOPE
SYNTHESIS
CONTROL UNIT — 273

PRESET
SYNTHESIS
PARAMETER — 272

# Fig.10

| CONTENT TYPE | TIMBRE/ATMOSPHERE | PARAMETER |
|---|---|---|
| HEALING MUSIC<br>ENVIRONMENTAL SOUND | CALM, RELAXED, SMOOTH | FREQUENCY BAND: ENTIRE BAND<br>MODULATION FREQUENCY BAND: 5 Hz TO 20 Hz<br>IS REDUCED (BY -6 dB) |
| CLASSIC<br>JAZZ | CALM, SMOOTH | FREQUENCY BAND: 100 Hz OR HIGHER<br>MODULATION FREQUENCY BAND: 30 Hz TO 150 Hz<br>IS REDUCED (BY -6 dB) |
| POP<br>ROCK<br>MOVIE SOUND | SHARP, CLEAR, STRONG<br>ATTACK, DRY SOUND | FREQUENCY BAND: 1 kHz TO 3.5 kHz<br>MODULATION FREQUENCY BAND: 200 Hz TO 1 kHz<br>IS INCREASED (BY + 6 dB) |

# Fig.11

252

282

$X_{k,0}$ ———▷——— $Y_{k,0}$
$W_{k,0}$

$X_{k,1}$ ———▷——— $Y_{k,1}$
$W_{k,1}$

$\vdots$

$X_{k,n}$ $Y_{k,n}$

$X_{k,N-1}$ ———▷——— $Y_{k,N-1}$
$W_{k,N-1}$

| WEIGHTING COEFFICIENT SETTING UNIT | 281 |

WEIGHT INFORMATION

# Fig. 12

NUMBER OF ENVELOPE SPECTRAL COEFFICIENTS: $N$

NUMBER OF TRANSMISSION BANDS: $Num\_band$

|  | $bin\ 0$ | $bin\ 1$ | $bin\ 2$ | $\cdots$ | $bin\ N\text{-}1$ |
|---|---|---|---|---|---|
| $Band\ 0$ | $W_{0,0}$ | $W_{0,1}$ | $W_{0,2}$ | | |
| $Band\ 1$ | $W_{1,0}$ | $W_{1,1}$ | $W_{1,2}$ | | |
| $Band\ 2$ | $W_{2,0}$ | $W_{2,1}$ | $W_{2,2}$ | | |
| $Band\ 3$ | $W_{3,0}$ | $W_{3,1}$ | $W_{3,2}$ | | |

$Band\ Num\_band\text{-}1$　　　　$W_{Num}$

EP 4 742 239 A1

# Ｆｉｇ．１３

252

292

$X_{k,0}$

$X_{k,1}$

$X_{k,N-1}$

$Y_{k,0}$

$Y_{k,1}$

$Y_{k,N-1}$

WEIGHTING COEFFICIENT
SETTING UNIT

291

WEIGHT INFORMATION

# Fig.14

ORIGINAL SOUND
SOURCE $x(t)$

BAND DIVISION
ENVELOPE
SEPARATION
$T \Rightarrow f$

ENVELOPE
$Ev_x(k,f)$

PROCESSED
ENVELOPE
$Ev_{x'}(k,f)$

TRAINING SO THAT THESE
TWO APPROACH EACH OTHER

(LOSS: MINIMIZE $\Sigma(Ev_x' - Ev_y)^2$)

SOUND SOURCE $y(t)$
PROCESSED TO HAVE
DESIRED TIMBRE

BAND DIVISION
ENVELOPE
SEPARATION
$T \Rightarrow f$

ENVELOPE
$Ev_y(k,f)$

# Ｆｉｇ．15

```
        ┌─────────────┐
        │    START    │
        └─────────────┘
               │
               ▼                                    S201
┌────────────────────────────────────────────────────┐
│  SEPARATE QUANTIZED SPECTRUM AND FLATTENING PARAMETER │
│       FROM ENCODED BITSTREAM FOR EACH BAND           │
└────────────────────────────────────────────────────┘
               │
               ▼                                    S202
┌────────────────────────────────────────────────────┐
│    DECODE QUANTIZED SPECTRUM TO OBTAIN ENVELOPE      │
│                   COMPONENT                          │
└────────────────────────────────────────────────────┘
               │
               ▼                                    S203
┌────────────────────────────────────────────────────┐
│   DECODE FLATTENING PARAMETER TO OBTAIN FLATTENED    │
│                   WAVEFORM                           │
└────────────────────────────────────────────────────┘
               │
               ▼                                    S204
┌────────────────────────────────────────────────────┐
│  GENERATE BAND-DIVIDED SIGNAL BY SYNTHESIZING QUANTIZED │
│        SPECTRUM AND FLATTENING PARAMETER             │
└────────────────────────────────────────────────────┘
               │
               ▼                                    S205
┌────────────────────────────────────────────────────┐
│   GENERATE AUDIO SIGNAL BY SYNTHESIZING BAND-DIVIDED │
│          SIGNALS OF RESPECTIVE BANDS                 │
└────────────────────────────────────────────────────┘
               │
               ▼
        ┌─────────────┐
        │     END     │
        └─────────────┘
```

# Fig.16

ENCODED BITSTREAM → DECODING/ DEMULTIPLEXING UNIT (210)

BAND DECODING UNIT (220)

220A:
- INVERSE QUANTIZATION UNIT (251)
- INVERSE FREQUENCY TRANSFORM UNIT (253)
- ENVELOPE PROCESSING UNIT (3111)
- FLATTENED WAVEFORM GENERATION UNIT (254)
- ENVELOPE SYNTHESIS UNIT (255)

BAND-DIVIDED SIGNAL

220B:
- INVERSE QUANTIZATION UNIT (261)
- INVERSE FREQUENCY TRANSFORM UNIT (262)

BAND SYNTHESIS UNIT (240) → AUDIO SIGNAL

WEIGHT INFORMATION

SYNTHESIS PARAMETER DETERMINATION UNIT (230)

200

40

# Fig.17

# Fig.18

WEIGHT INFORMATION

230

SYNTHESIS PARAMETER
DETERMINATION UNIT

331 — USER PROFILE
ACQUISITION UNIT

ENVELOPE
SYNTHESIS
CONTROL UNIT — 273

AUDITORY CHARACTERISTICS OF USER
PREFERENCE OF USER
DEVICE PROPERTIES OF HEARABLE DEVICE

PRESET
SYNTHESIS
PARAMETER — 272

# Fig.19

WEIGHT INFORMATION

230

SYNTHESIS PARAMETER
DETERMINATION UNIT

341 — TERMINAL
INFORMATION
ACQUISITION UNIT

ENVELOPE
SYNTHESIS
CONTROL UNIT — 273

REMAINING BATTERY LEVEL
CPU UTILIZATION
MEMORY CONSUMPTION
.
.
.

PRESET
SYNTHESIS
PARAMETER — 272

# Fig.20

# Fig. 21

EP 4 742 239 A1

# Fig.22

# Ｆｉｇ．23

| TIMBRE TO BE CHANGED | PARAMETER |
|---|---|
| FLUCTUATION | FREQUENCY BAND: ENTIRE BAND<br>MODULATION FREQUENCY BAND: 5 Hz TO 20 Hz |
| ROUGHNESS | FREQUENCY BAND: 100 Hz OR HIGHER<br>MODULATION FREQUENCY BAND: 30 Hz TO 150 Hz |
| SHARPNESS (ATTACK FEELING AND DRYNESS) | FREQUENCY BAND: 1 kHz TO 3.5 kHz<br>MODULATION FREQUENCY BAND: 200 Hz TO 1 kHz |

# Fig.24

## INTERNATIONAL SEARCH REPORT

| International application No. |
|---|
| **PCT/JP2024/021972** |

**A. CLASSIFICATION OF SUBJECT MATTER**

*G10L 19/02*(2013.01)i; *G10L 19/00*(2013.01)i; *G10L 19/002*(2013.01)i; *G10L 19/008*(2013.01)i; *G10L 19/20*(2013.01)i; *G10L 19/24*(2013.01)i; *G10L 19/035*(2013.01)i; *G10L 19/038*(2013.01)i
FI: G10L19/02 150; G10L19/00 330B; G10L19/008 200; G10L19/002; G10L19/035 Z; G10L19/038; G10L19/20; G10L19/24

According to International Patent Classification (IPC) or to both national classification and IPC

**B. FIELDS SEARCHED**

Minimum documentation searched (classification system followed by classification symbols)

G10L19/02; G10L19/00; G10L19/002; G10L19/008; G10L19/20; G10L19/24; G10L19/035; G10L19/038

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 10-78797 A (NIPPON TELEGRAPH AND TELEPHONE CORPORATION) 24 March 1998 (1998-03-24) paragraphs [0001], [0008]-[0009], [0014], [0017]-[0025], fig. 1-3 | 1-3, 6-11, 13-15, 17-20 |
| A | | 4-5, 12, 16 |
| Y | JP 2001-100798 A (MATSUSHITA ELECTRIC INDUSTRIAL CO., LTD.) 13 April 2001 (2001-04-13) paragraphs [0013], [0041]-[0050], fig. 1 | 1-3, 6-11, 13-15, 17-20 |
| Y | JP 8-146997 A (HITACHI, LTD.) 07 June 1996 (1996-06-07) paragraphs [0018], [0033]-[0035], [0113], [0117], fig. 2 | 3 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **08 July 2024** | **23 July 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**
Information on patent family members

International application No.

**PCT/JP2024/021972**

| Patent document cited in search report | | | Publication date (day/month/year) | Patent family member(s) | Publication date (day/month/year) |
|---|---|---|---|---|---|
| JP | 10-78797 | A | 24 March 1998 | (Family: none) | |
| JP | 2001-100798 | A | 13 April 2001 | EP 1132891 A1 paragraphs [0013], [0017]-[0024], fig. 2 WO 2001/024164 A1 | |
| JP | 8-146997 | A | 07 June 1996 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9146593 A

**Non-patent literature cited in the description**

- **MASAYUKI TAKADA**. Calculation Methods of Sound Quality Metrics and Its Application. *Journal of the Acoustical Society of Japan*, 2019, vol. 75 (10), 582-589
- **DAU, T et al.** Modeling auditory processing of amplitude modulation. I. Detection and masking with narrow-band carriers. *Journal of the Acoustical Society of America*, 1997, vol. 102, 2892-905
- **S. VAN DE PAR** ; **S. DISCH** ; **A. NIEDERMEIER** ; **B. EDLER**. Informed postprocessing for auditory roughness removal for low-bitrate audio coders. *AES Convention Paper*, October 2021 (10534)
- **OKAMOTO YASUHIDE** ; **KANZAKI AKIRA** ; **NUKANO AYAKO** ; **NAKAICHI KENJI** ; **MORIMOTO RYUJI** ; **HARADA KOUTA** ; **KUBOTA ERI** ; **OGAWA IKU**. Measurement of Temporal Resolution in Presbyacusis. *AUDIOLGY JAPAN*, 2014, vol. 57 (6), 694-702
- **DRULLMAN, R et al.** Effect of reducing slow temporal modulations on speech reception. *The Journal of the Acoustical Society of America*, 1994, vol. 95 (5), 2670-80